# EUROPEAN PATENT SPECIFICATION

(11) **EP 0 778 577 B1**
(45) Date of publication and mention of the grant of the patent: **12.06.2002**
(21) Application number: 97101927.8
(22) Date of filing: 29.11.1989
(51) Int. Cl.: G11C 7/00, G09G 1/16

(54) **A Synchronous semiconductor memory integrated circuit, a method for accessing said memory and a system comprising such a memory**
Integrierte Schaltung mit synchronem Halbleiter-Speicher, Methode zum Zugriff auf diesen Speicher und System mit einem solchen Speicher
Circuit intégré à mémoire synchrone à semi-conducteurs, méthode d'accès et système comprenant cette mémoire

(30) Priority: 29.11.1988 US 277637; 29.11.1988 US 278333; 29.11.1988 US 277687
(43) Date of publication of application: 11.06.1997
(62) Divisional of application: 94116991.4
(73) Proprietor: MATSUSHITA ELECTRIC INDUSTRIAL CO., LTD., Kadoma-shi, Osaka 571-8501 (JP)
(72) Inventor: Harlin, Roy Edward, Santa Clara, California 95054 (US); Herrington, Richard Arthur, Fort Collins, Colorado 80525 (US)
(74) Representative: Schwabe - Sandmair - Marx

(56) References cited:
- JP-A- 61 288 240
- US-A- 4 712 190
- MASAYOSHI NAKANE ET AL: "VIDEO RAM CHIPS DESIGNED FOR COMPUTER GRAPHICS" JEE JOURNAL OF ELECTRONIC ENGINEERING, vol. 24, no. 251, 1 November 1987, pages 28-31, XP000111482

## Description

The invention relates to a synchronous dynamic random access memory integrated circuit, a method for accessing such a memory and a system comprising such a memory, a circuit for accessing said memory and a bus connecting said circuit to said memory.

With the cost per bit of a semiconductor memory and the price of computer systems dropping, personal work stations and other computer systems using graphics such as CAD/CAM systems are becoming more readily available. A crucial component in such systems is the dynamic video RAM which supports the graphics applications.

Conventional dynamic video RAMS, available on multichips, have a random port and a serial port enabling a computer to access the dynamic video RAM through the random port and enabling the serial port to deliver the necessary graphics information to drive, for example, a cclor monitor.

In designing dynamic video RAMS, several features are of critical importance.

First, it is important to package the video RAM on a single integrated circuit chip minimizing the number of external pins from the chip. Secondly, it is important to maximize the memory contained on the chip. Third, it is important to perform as many of the modification operations on chip to increase the speed, rather than having off chip hardware perform these operations at a much slower rate off the chip. Fourth, it is important to maximize the addressing capabilities of the data stored within the chip. The number of clock inputs controlling the random port of the video RAM leads to complexity and slower speed.

The following patents are representative of issued patents involving dynamic RAMs commercially available. In each of these patents, no provision is made for incorporating both the conventional image mode addressing and the vector mode addressing of the present invention onto the chip carrying the RAM. The conventional image mode addressing is slow when a vertical line in the screen is to be modified. Each scan line in memory must be addressed even though each scan line contains only one pixel in the vertical line to be modified. Hence, a substantial number of scan lines in memory must be addressed to modify the line. Under the teachings of the present invention, the vertical line can be addressed as a vertical vector in a page and, therefore, only those vertical vectors comprising the vertical line need to be addressed. This substantially speeds up the addressing for vertical lines in the dynamic video RAM.

In each of these patents, further, no provision is made for incorporating the drawing or replacement rules onto the chip carrying the RAM. Rather, in order to modify a given line of information stored in the RAM, the information to be modified must be read out from the dynamic video RAM and modified off chip according to the acquired logical operation. The present invention performs the drawing or replacement rule with circuitry located on the chip and further is able to selectively mask the areas of modified information to be read back into the RAM.

US-A 4,688,197 sets forth a video computer system having a RAM chip with a shift register connected to its serial output terminal which is actuated by a first clock and a second clock is utilized to load the serial chip register.

US-A 4,689,741 pertains to the same invention as the Novak patent but provides for coupling of data between column lines and the chip register to prevent two or more different data bits from simultaneously appearing.

US-A 4,665,495 sets forth a single chip dynamic RAM controller and CRT controller system arrangement. This invention minimizes the control circuit of prior systems thus eliminating potential bottle necks at the RAM by utilizing a single controller. A related U.S. patent also issued to Thaden et al. is USP 4,656,596. The RAM of Thaden resides on a chip separated from the controller chip and the control signals are sent to the RAM.

US-A 4,546,451 sets forth a dynamic RAM which permits "page mode" addressing horizontal or vertical vector addressing. While Bruce shows a graphics controller device (GDC) clock, this clock is delivered from the RAM chip to the separate GDC. More importantly, the separate GDC must provide the load, count enable and other control signals directly to the RAM chip.

US-A 4,646,270 sets forth a video graphic dynamic RAM having the capability of serially reading out data at a high rate of speed while performing standard RAM operations.

A need exists for a dynamic video RAM which performs both vector mode addressing (i.e., horizontal and vertical vectors) and image mode addressing on a single chip containing high capacity memory, contains the necessary hardware to perform on-chip modification of the stored video information, and accomplishes this with a minimum number of external pins.

There is no disclosure in any one of the above patents of circuitry to perform drawing rule modification on chip with the random access memory.

In the target specification of the Hitachi HM53462 Multi Port DRAM, logic operation and masking occur on a single chip. However, in this approach the system must first deliver the logic operation to the chip and then cycle to address the memory, deliver the new source data, read from memory and then modify the read information.

A need exists not only for providing the drawing rule and masking circuitry on the chip with the RAM but also to maximize the performance by delivering the drawing rule with the addresses to the chip at the same time.

EP-A-0 197 413 shows that locations in a RAM sharing a common row address but with different column addresses are sequentially accessed. Thus the modification of a vertical or horizontal line requires addressing the locations of the RAM for a plurality of times.

Supplementarily, US-A-4 442 503, US-A-3,996,559 and WO-A-84 03970 show RAM devices which are comparable with this according to EP-A-0 197 413.

In the above patents, no provision is made for utilizing a single clock on the random port side of the RAM to control the operation of the RAM including the loading of information into the address and data registers, the operation of the RAM and the modification of the information in the RAM.

US-A 4,712,190 discloses a synchronous dynamic random access memory integrated circuit comprising a memory block including a plurality of memory cells for storing information, an input for receiving an external clock signal, address input means for receiving an address in response to the external clock signal and providing said address as an output and control means for outputting an internal control signal defining an internal operation of said synchronous dynamic random access memory integrated circuit in response to an external control input.

It is the object of the invention to accelerate memory access of synchronous dynamic random access memory integrated circuits.

This object is solved by the subject-matters of the independent claims.

Preferred embodiments of the invention are disclosed by the subclaims.

Thus, the invention described herein makes possible the objectives of:
(1) providing a dynamic (video) random access memory in which the addressing for vertical lines is speeded up;
(2) providing a dynamic (video) random access memory in which a vertical line can be addressed as a vertical vector in a page and, therefore, only those vertical vectors comprising the vertical line need to be addressed;
(3) providing a dynamic (video) random access memory which can perform both vector mode addressing (horizontal and vertical vectors) and image mode addressing on a single chip containing high capacity memory;
(4) providing a dynamic (video) random access memory which contains the necessary hardware to perform on-chip modification of the stored (video) information;
(5) providing a dynamic (video) random access memory which has a minimum number of external pins;
(6) providing a dynamic (video) random access memory which has a circuitry to perform drawing rule modification on a chip with the random access memory;
(7) providing a dynamic (video) random access memory which can provide the drawing rule and masking circuitry on a chip with the random access memory and maximize the performance by delivering the drawing rule with the address to the chip at the same time;
(8) providing a dynamic random access memory which can utilize a single clock on the random port side of the memory to control the operation of the memory including the loading of information into the address and data registers, the operation of the memory and the modification of the information in the memory; and
(9) providing a dynamic random access memory which can minimize the number of signal paths to and from the chip while providing for a faster operation.

### BRIEF DESCRIPTION OF THE DRAWINGS

This invention may be better understood and its numerous objects and advantages will become apparent to those skilled in the art by reference to the accompanying drawings as follows:
Figure 1 is a block diagram of a system incorporating the dynamic (video) RAM of the present invention.
Figure 2 illustrates the screen of the color monitor 20 of the system of Figure 1 and a partial scan line.
Figure 3 illustrates the serial data transfer address of the present invention.
Figure 4 illustrates the most significant address and least significent address of the serial data transfer address of Figure 3.
Figure 5 sets forth the page layout of the screen of the color monitor 20 of the present invention.
Figure 6 shows vectors within an individual page.
Figure 7 is the format for a page address.
Figure 8 shows the most significent address and least significant address bits of the page address of Figure 7.
Figure 9 shows the image mode addressing scheme of the color monitor of the present invention.
Figure 10 shows the format of the image address.
Figure 11 shows the most significant and least significent address portions of the image address of Figure 10.
Figure 12 illustrates the structure of a single chip of the dynamic (video) RAM of the present invention.
Figure 13 sets forth the circuit block diagram of the dynamic (video) RAM chip of the present invention.
Figure 14 sets forth the format of the data inputs for the image mode of operation.
Figure 15 sets forth the format for the data inputs for the vector mode of operation.
Figure 16 is an illustration of a vector mode operation.
Figure 17 is an illustration of an image mode operation.
Figure 18 shows the timing for serial data transfer.
Figure 19 shows the timing for vector write.
Figure 20 shows the timing for vector write, page mode.
Figure 21 shows the timing for image read/write.
Figure 22 shows the timing for image read/write, page mode.
Figure 23 shows the timing for image read modify write.
Figure 24 sets forth an implementation of a random port state machine.

### DESCRIPTION OF THE PREFERRED EMBODIMENTS

### 1. General Description

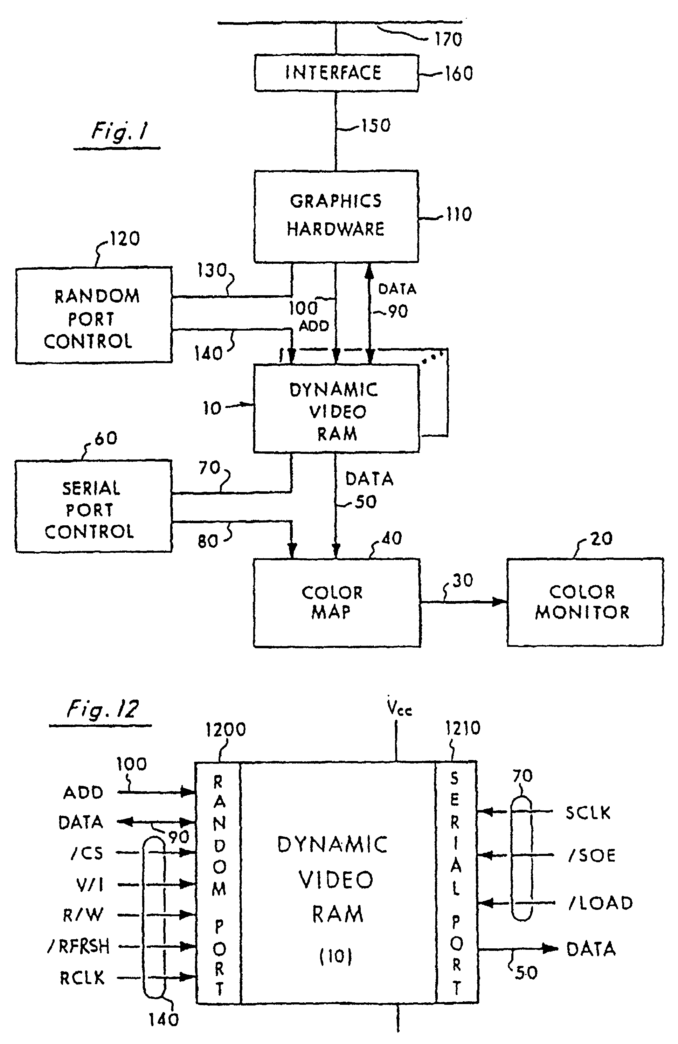

Figure 1 sets forth the dynamic (video) RAM 10 of the present invention in a system environment having a color monitor 20 interconnected over lines 30 with a color map circuit 40. The color map circuit 40 is in turn connected over video data bus 50 to the dynamic (video) RAM 10 of the present invention. Both the dynamic (video) RAM 10 and the color map 40 are under control of a serial port control 60 over lines 70 and 80. The dynamic (video) RAM 10 is also interconnected over a data bus 90 and an address bus 100 to a graphics hardware circuit 110. A random port controller 120 controls the graphic hardware circuit 110 over lines 130 and the dynamic (video) RAM 10 over lines 140. The graphics hardware circuit 110 is interconnected over lines 150 to an interface circuit 160 which communicates with a standard bus 170.

The dynamic (video) RAM 10 of the present invention stores the image which is actually being displayed on the color monitor 20. The stored information in the video RAM 10 is delivered over the data bus 50, sequentially, to the color map circuit 40 for display on the monitor 20. The serial port control 60 controls the transfer of the stored information in the dynamic (video) RAM 10 to the color map 40.

When it is desired to change the stored information in the dynamic (video) RAM 10 in order to change the displayed image on the color monitor 20, appropriate commands come over bus 170 such as from a CPU or the like, not shown, and is received by the interface circuit 160 for delivery into the graphics hardware circuit 110. The random port control 120 controls the changing of the information stored in the dynamic (video) RAM based upon the information received by the graphics hardware from bus 150. The address for the information to be changed is delivered over address bus 100 and the data for the change is delivered over data bus 90. In this fashion, the dynamic (video) RAM information can be modified to change the image on the color monitor 20.

It is to be expressly understood that the system environment shown in Figure 1 is for purposes of illustration only and that the dynamic (video) RAM of the present invention could be utilized in other environments. For example, a color map and color monitor may not be present.

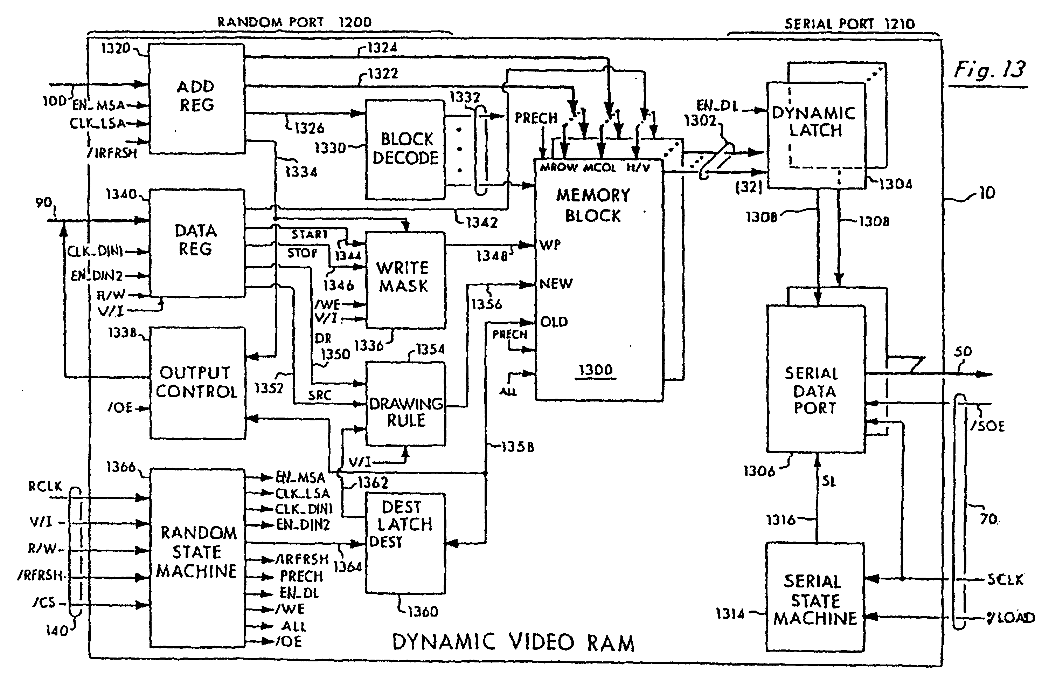

In the preferred embodiment of a single chip as shown in Figure 12, the random port bus comprises an address bus 100 which is eleven bits wide, a data bus 90 which is sixteen bits wide and a control bus 140 which is five bits wide. The serial port bus comprises a data bus 50 which is four bits wide and a control bus 70 which is three bits wide. Hence, the dynamic (video) RAM 10 has thirty-nine pins plus four pins for power and ground for a total of forty-four. The present invention as set forth next, however, is not limited to a configuration having this number of pins. As shown in Figure 1, a number of these single chips can be utilized in a system environment. The /CS control enable carried by control bus 140 selects which chip is accessed.

Three modes of addressing and operating the dynamic (video) RAM 10 over address bus 100 are present. They are (a) the serial data transfer mode, (b) the vector address mode, and (c) the image address mode. Each mode will be discussed in the following.

### a. Serial Data Transfer Mode

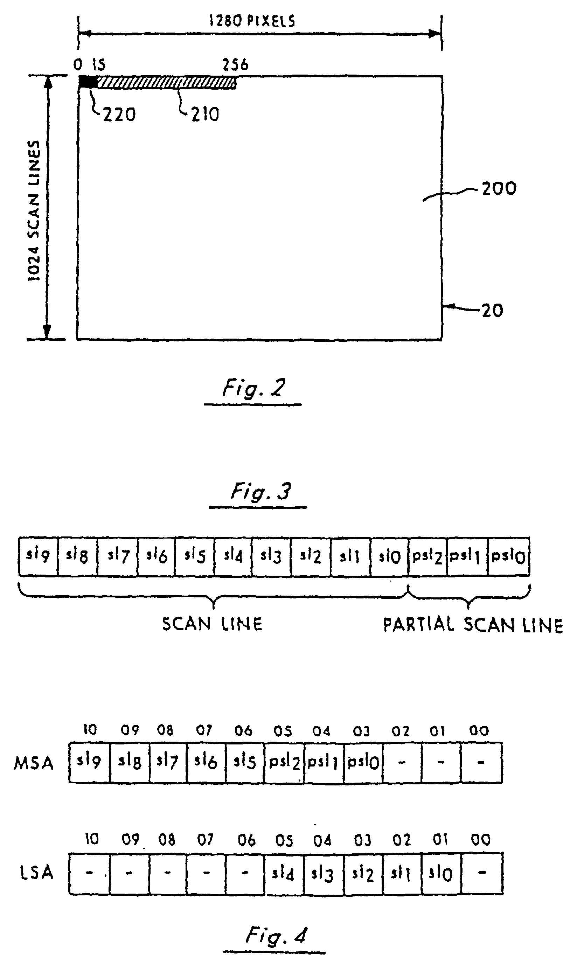

In Figure 2, the screen 200 of monitor 20 is shown. Screen 200 is conventional and may have, for example,1280 pixels across the screen in a horizontal line with 1024 scan or raster lines in the vertical direction. It is to be expressly understood that any configuration of pixels and scan lines could be used under the teachings of the present invention. In Figure 2, a partial scan line 210 is also shown. A "partial scan line" is defined herein to be 256 contiguous pixels in a scan line. A "word" is defined to be 16 pixels. Hence, a partial scan line contains 16 words. This corresponds to conventional image mode addressing found in other video RAM devices.

The dynamic (video) RAM 10 of the present invention is capable of being addressed over random port address bus 100 to perform serial port data transfers over data bus 50 under the serial port control 60. In Figure 3, the serial data transfer address is shown. The 1024 scan lines are selected by the ten bit scan line field and the partial scan lines 210 are selected by the three bit partial scan line field. A total of thirteen bits are required to perform serial data transfer addressing. Since address bus 100 is only eleven bits wide, two addresses are delivered as shown in Figure 4. The first transfer being the most significant address (MSA) and the second transfer being the least significent address (LSA). Again, it is to be expressly understood that the present invention is not limited to this number of bits or to this configuration of addressing.

Figures 2-4, therefore, show the addressing of the dynamic (video) RAM 10 of the present invention in the serial data transfer mode.

### b. Vector Addressing Mode

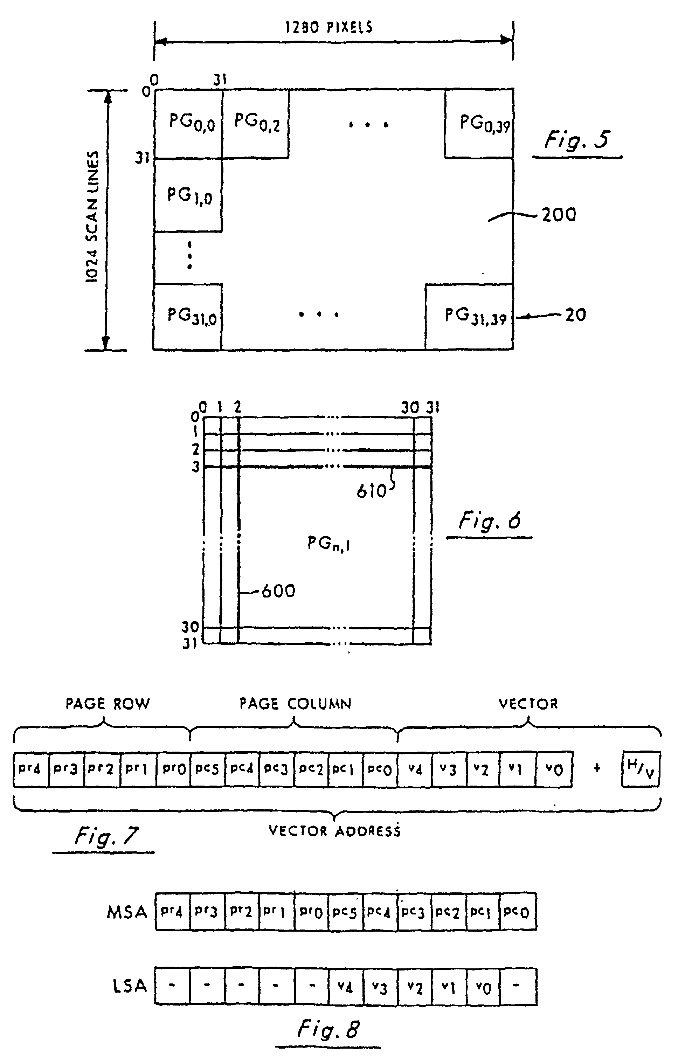

The present invention provides a mode of vector addressing wherein a page can be accessed either horizontally or vertically on the screen. This is shown in Figures 5-8.

A page is defined to be a 32 by 32 array of pixels. In Figure 5, the page PG (0,0) has 32 horizontal scan lines by 32 horizontal pixels. It is to be expressly understood that a page could be of any similar "m" x "n" configuration. The screen monitor of Figure 5 has 32 times 40 or 1280 pages. The term "page column" is defined to be the horizontal location of a page and the term "page row" is the vertical location of a page. For example, for page PG (31,39), the page column is 39 and the page row is 31. The page row in the preferred embodiment of 32 rows can be addressed by a 5 bit word. For example, the page row value for page PG (31,0) is 11111. Likewise, the 40 page columns, in the preferred invention of 1280 pixels can be addressed by a six bit word.

Figure 6 shows an individual page PG (n,i). The term "vector column" identifies the horizontal location of a vector within a page. For example, vector 600 is located in vertical row 2. The term "vector row" is defined to mean the vertical location at a vector within a page. For example, vector 610 is located in column 3. In the vector mode addressing scheme of the present invention, one bit, the H/V bit is used to define whether the vector is horizontal 610 or vertical 600. Five bits are then utilized to locate the vector within the page. For example, for the vector 610, the H/V bit equals 1 to designate a horizontal vector and the remaining 5 bits are 00011. The vertical vector 600 has the H/V bit set to O and the remaining 5 bits are 00010.

The vector addressing scheme shown in Figures 5 and 6 is unique to the present invention and permits not only a select page PG to be addressed but also to address a vertical or horizontal vector within the page.

Therefore, the necessary page address, as shown in Figure 7 and in the preferred embodiment, is a 16 bit word having 5 bits to identify the page row bits to identify the page column, and 5 bits to identify the vector. The additional horizontal/vertical (H/V) bit identifies whether the vector is horizontal or vertical within the page. In this fashion, a specific vector such as either vector 600 or 610 in Figure 6 in a selected page on the screen 200 can be addressed.

Since the address bus 100 in Figure 1 is 11 bits wide, the graphics hardware 110 outputs the vector address of Figure 7 as two separate transfers. The first transfer being the most significant address (MSA) and the second address being the least significant address (LSA) both shown in Figure 8.

It is to be expressly understood that Figures 5 through 8 set forth one approach under the teachings of the present invention and that other bit layouts and address configurations could be used to accomplish the vector mode of addressing.

### c.Image Adress Mode

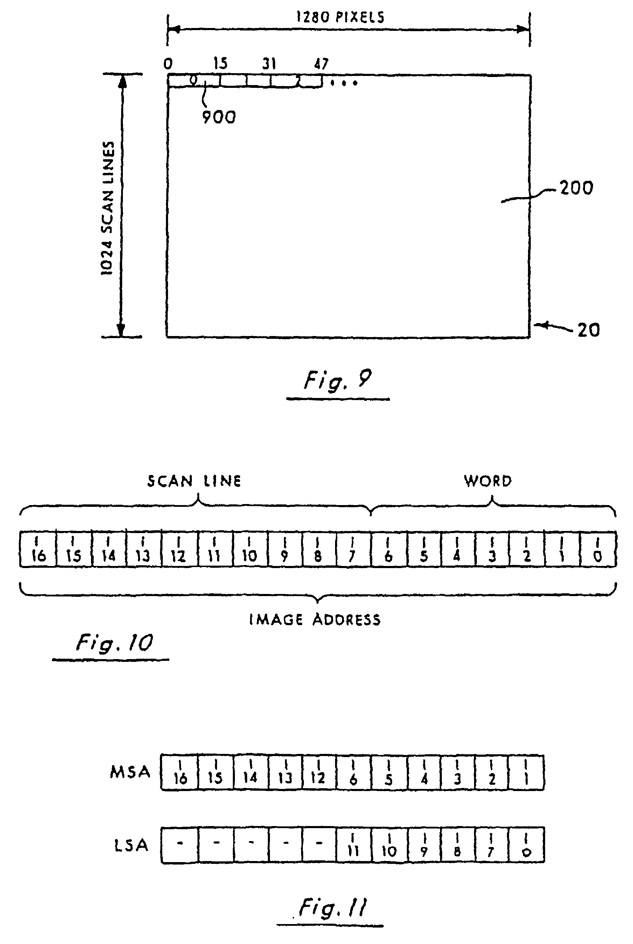

The present invention is also capable of image mode addressing as shown in Figures 9-11. To locate a scan line on screen 200 would require 10 bits in the example shown of 1024 scan liner. A scan line is defined as the set of contiguous pixels making up a complete scan line on a raster scan display. There are eighty 16 bit words in a scan line. Therefore, seven bits are required to locate a word in a given scan line. Hence, the image address as shown in Figure 10 has 10 bits to identify the scan line and 7 bits to identify a word within the scan line. Because of the structure of the video RAM of the present invention, the address bus 100 as shown in Figure 1 is limited to 11 bits and, therefore, as shown in Figure 11, the image address is transferred in an MSA cycle and an LSA cycle.

As discussed above, three modes of addressing occur on address bus 100. These three modes are serial data transfer (Figures 2-4), vector mode addressing (Figures 5-8) and image mode addressing (Figures 9-11) and cause the (video) RAM 10 of the present invention to operate in these different modes. The serial data transfer mode effectuates transfer of information from the RAM 10 over data bus 50. The vector and image modes permit changes to be made to the information stored within the RAM 10.

### d. Chip Configuration

In Figure 12, the dynamic (video) RAM 10 of the present invention is shown as a discrete single integrated circuit chip. With reference back to Figure 1, the random port side 1200 of the RAM 10 has the following pin designations:
1. Address Bus 100 (11 pins)
2. Data Bus 90 (16 pins)
3. /CS-chip select
4. V/I - Vector/Image Select
5. R/W - Read/Write Select
6. RFRSH - Refresh
7. RCLK - Random Port Clock

On the serial port side 1210 of the dynamic (video) RAM 10 the following pins are designated:
1. SCLK - Serial Clock
2. /SOE - Serial Output Enable
3. /LOAD - Load Signal
4. Data Bus (4 pins)

In addition, two voltage, Vcc, pins and two ground pins, Vss, are required.

The chip select signal (/CS) selects which chip is being selected. For example, in Figure 1, any number of chips 10 can be positioned within the system environment. If, for example, sixteen chips are required, then the appropriate /CS pin would be activated by the random port control 120.

As previously discussed, the vector-image signal (V/I) determined whether the chip is being addressed in the vector or image modes. In the preferred embodiment, when V/I is high, the chip is in the vector mode and when the V/I signal is low, the chip executes in the image mode.

The read/write signal (R/W) performs as follows. When R/W is high, the chip 10 is in the read mode and data appears on data bus 90. When R/W is low, the chip is in the write mode and the data is written into the memory found within chip 10. The following modes of operation occur within the chip 10:

**TABLE I**

| V/I | R/W | Cycle |
|---|---|---|
| 0 | 0 | image write |
| 0 | 1 | image read |
| 1 | 0 | vector write |
| 1 | 1 | serial data transfer |

The random port clock (RCLK) is a single clock signal delivered to the chip 10. A11 internal random port operations of the chip 10 are synchronized with and derived from this clock signal. This is the only clock signal to the random port and is preferably one megahertz.

The address signals on random port address bus 100 carries the bit addresses for the MSA and LSA addresses as shown in Figure 4 for serial data transfer, in Figure 8 for vector mode addressing, and in Figure 11 for image mode addressing.

The data appearing on random port data bus 90 is sixteen parallel bits and is delivered into the chip 10 as two sets of data - DIN1 and DIN2. This is shown in the following table

**TABLE II**

| Mode | DIN1 | DIN2 |
|---|---|---|
| Vector | DR, START/STOP, H/V | - |
| Image | DR, START/STOP | Read or Write |

(Where DR = Drawing Rule, H/V = Horizontal/Vertical)

Also delivered to the RAM 10 of the present invention from the random port control 120 is a /RFRSH which is used as an internal refresh signal.

The RAM 10 of the present invention also receives control signals from the serial port control 60 over serial port control bus 70. The SCLK signal is a single serial port clock, the /SOE is a serial output enable signal. When /SOE is low, serial read data appears on the data bus 50. The /LOAD is a data load signal. The present invention only uses a single clock on the serial port 1210 to transfer data to the serial port.

The two Vcc pins shown in Figure 12 provide power which in the preferred embodiment is plus five volts and the Vss pins are the two ground pins. More or less than two pins for power and ground can be used under the teachings of the present invention.

The single integrated chip shown in Figure 12 contains in the random port 1200 and in the serial port 1210 all of the necessary circuitry to operate the RAM in the three modes of operation (Serial data transfer, Vector addressing and Image Addressing). The random port is controlled through receipt of one of a plurality of sets of control enables over bus 140 which configure the RAM to operate in its various modes of operation. The delivery of the single clock RCLK then is used to produce the necessary internal control enables to execute the selected mode of operation.

The signals appearing on the pins shown in Figure 12 will now be discussed in the following detailed description of the internal configuration and operation of the dynamic (video) RAM 10 of the present invention. It is to be expressly understood that the pin number and selection represents only a preferred embodiment and that other embodiments may be designed within the teachings of the present invention.

### 2. Detailed Description

This section discusses the detailed structural embodiment of the dynamic (video) RAM chip 10 of the present invention and the preferred operation. The individual register, latch, shift, and other disclosed circuits are individually conventional in operation and design. The combined circuit layout, however, is unique and while one preferred layout is shown, it is to be expressly understood that other layouts based upon the teachings of this invention could be used.

### a. Serial Port Side 1210 Configuration

The components of the dynamic (video) RAM 10 of the present invention are set forth in Figure 13 to include a plurality of memory blocks 1300. Each memory block 1300 is, in the preferred embodiment, 160 memory cells by 1024 memory cells. There are 8 memory blocks for a total of 1,310,720 cells on a single chip although it is to be expressly understood that any number could be used.

The output from the memory block 1300 is delivered over lines 1302 into a plurality of dynamic latches 1304. Each dynamic latch 1304 stores 32 bits of information as read from its respective interconnected memory block 1300. The eight latches, therefore, hold 256 bits or a partial scan line. The output of each dynamic latch 1304 is delivered to a respective serial data port register 1306 over interconnecting lines 1308. Each serial data port register 1306 contains a 32 bit register which is capable of delivering 4 bits, in a serial fashion, onto data bus 50 for delivery, for example, inlo the color map 40 as shown in Figure 1. The control signals 70 from the serial port control 60 are delivered into the serial state machine 1314. Which is interconnected over lines 1316 to the serial data port in order to control the serial reading of information from the dynamic latch 1304.

Hence, the dynamic latch 1304, the serial data port 1306, and the serial state machine 1314 constitute the serial port side 1210 of the dynamic (video) RAM 10 of the present invention.

### b. Random Port Side 1200 Configuration

The random port side 1200 includes an address register 1320 which is interconnected to the random port address bus 100 and is further connected over lines 1322 (eight bits) and 1324 (five bits) to the memory block 1300. The address register 1320 is also interconnected over lines 1326 (three bits) to a block decode circuit 1330 which is interconnected over lines 1332 to the memory block 1300. The address register is also interconnected over line 1334 to the write mask 1336 and to the output control 1338.

The data register,1340 is interconnected to the data bus 90 and is further interconnected over line 1342 (H/V bit) to the memory block 1300, over lines 1344 (START - five bits) and 1346 (STOP - five bits) to the write mask 1336. The write mask 1336 is further interconnected over lines 1348 (32 bits) to the memory block 1300. The data register 1340 is further interconnected over lines 1350 (four bits) and 1352 (sixteen bits) to the drawing rule circuit 1354 which in turn is interconnected over lines 1356 (thirty-two bits) to the memory block 1300.

The output control 1338 is also interconnected to the random port data bus 90 and is also interconnected over lines 1358 to the memory block 1300. Destination latch 1360 is also connected to lines 1358 and is further connected over lines 1362 (thirty-two bits) to the drawing rule circuit 1354 and over line 1364 to the random state machine 1366. The random state machine 1366 receives the random port control input signals over random port control bus 140.

Hence, the address register 1320, the block decode circuit 1330, the data register 1340, the write mask 1336, the output control 1338, the drawing rule circuit 1354, the destination latch 1360, and the random state machine 1366 constitute the random port side 1200 of the dynamic (video) RAM 10 of the present invention. While a preferred embodiment of the present invention is shown, variations to the design could be made under the teachings of the claimed invention. For example, the latch 1360 could be designed using strobed combinational logic to deliver or hold the stored video information.

### c. serial Port Side 1210 Operation

The operation of the dynamic (video) RAM of the present invention will first be discussed with respect to the operation of the serial data transfer mode of operation wherein the information contained within the memory block 1300 is issued to generate the image, for example, on the color monitor 20 of Figure 1. This scan line transfer mode of operation utilizes the addressing techniques shown in Figures 2-4.

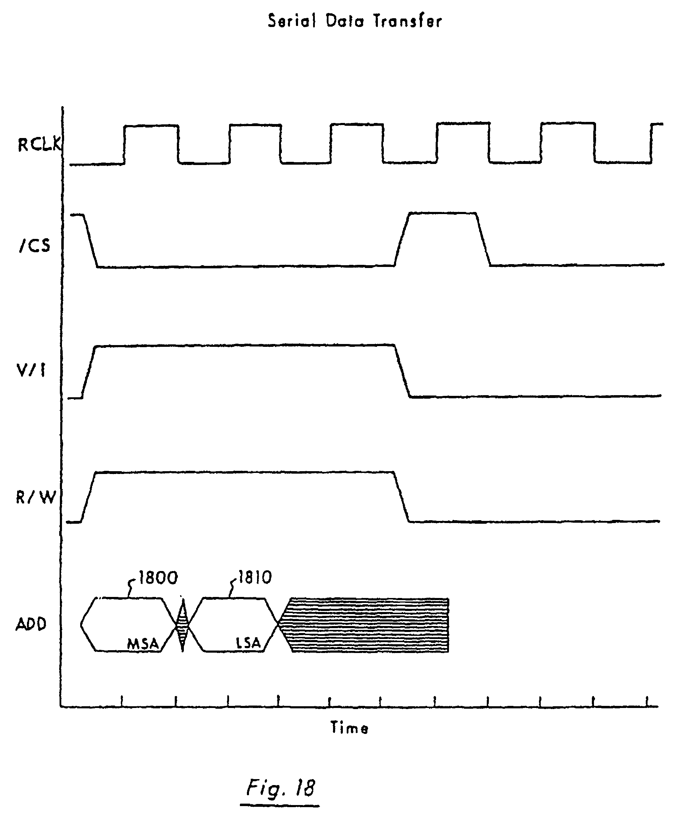

In the timing and control diagram of Figure 18, the RCLK, /CS, V/I, and R/W enables are delivered over random port control bus 140 from the random port control 120. The address, ADD, is delivered over bus 100 from the graphics hardware 110. The /CS signal selects which dynamic (video) RAM chip 10 is being activated. In this mode of operation, i.e., serial data transfer, the R/W bit is high to read the memory block 1300. When a serial data transfer occurs, the V/I bit set high (see Table I) (i.e., vector or image) is also selected and as shown in Table I the vector mode is selected. Hence, the address (MSA and LSA) of the data to be transferred from the memory block 1300 to the dynamic latch 1304 is contained on bus 100 - see Figure 4. The single clock signal RCLK causes the random state machine 1366 to input the address (MSA and LSA) into the address register 1320 during a first time interval (i.e., at times 1800 and 1810) as shown in Figure 18. When it is desired to read the memory block 1300 so that the contents can be serially delivered to the color map 40, the transfer of the addressed partial scan line for a screen refresh occurs in the following manner. Thirty two bits of information from each of the eight memory blocks 1300 are read over lines 1302 into the dynamic latches 1304. The dynamic latch 1304 receives a signal over line EN-DL from the random state machine 1366 indicating that it is to read the data from the memory block. A11 eight dynamic latches are so enabled and each will read in 32 bits for a 256 bit partial scan line. After reading, EN-DL is appropriately activated to deliver the read information over lines 1308 into the serial data port 1306. Again, this is a parallel transfer of 32 bits of information for each of the eight serial shift registers. The serial data port 1306 comprises shift registers. Each of the eight serial data ports 1306 is under control of the serial state machine 1314 and the serial clock SCLK. When the serial data port 1306 is enabled over line SL, each clock signal transfers out four bits from a given serial data port 1306 to data bus 50.

The transfer of the data occurs in the following fashion. Serial state machine 1314 has a counter contained therein which counts the serial clock pulses SCLK. Hence, as the SCLK pulses come in, they are delivered to the serial data port 1306 which after eight such pulses sequentially gates out the 32 bits stored therein, four bits at a time, to the video data bus 50. Then, the next eight SCLK pulees cause the output of the 32 bits out from that next memory block portion to the video data bus 50. In this fashion, the serial state machine 1314 is capable of causing the serial data port to output the stored data from eech of serial data port 1306 until a partial scan line is output from the serial data port 1306. After a partial scan line is output, a /LOAD signal is received over serial port control bus 70 to the serial state machine 1314 and over line 1316 to load from the dynamic latch all of the serial data port 1306 with the data for the next partial scan line. The /SOE input to serial data port 1306 enables the multiplexer to deliver the information four bits at a time to the color map 40.

It is to be expressly understood that other conventional configurations for the serial port could be utilized under the teachings of the present invention. The serial port is asynchronous from the random port and can transfer data over bus 50 while the chip 10 is performing other operations.

### d. Random Part Side 1200 Operation

The operation of the random port 1200 of the dynamic (video) RAM 10 will now be explained.

The term "drawing rule" is defined to be a logical operator combining a "source" and a "destination" upon write to the memory block 1300. Drawing rules, in the preferred embodiment, are specified by the following table:

**TABLE III**

| Drawing Rule | Product |
|---|---|
| 0000 | clear (all zeroes) |
| 0001 | source and destination |
| 0010 | source and (not destination) |
| 0011 | source |
| | |
| 0100 | (not source) and destination |
| 0101 | destination |
| 0110 | source xor destination |
| 0111 | source or destination |
| | |
| 1000 | source nor destination |
| 1001 | source nxor destination |
| 1010 | not destination |
| 1011 | source or (not destination) |
| | |
| 1100 | not source |
| 1101 | (not source) or destination |
| 1110 | source nand destination |
| 1111 | set (all ones) |

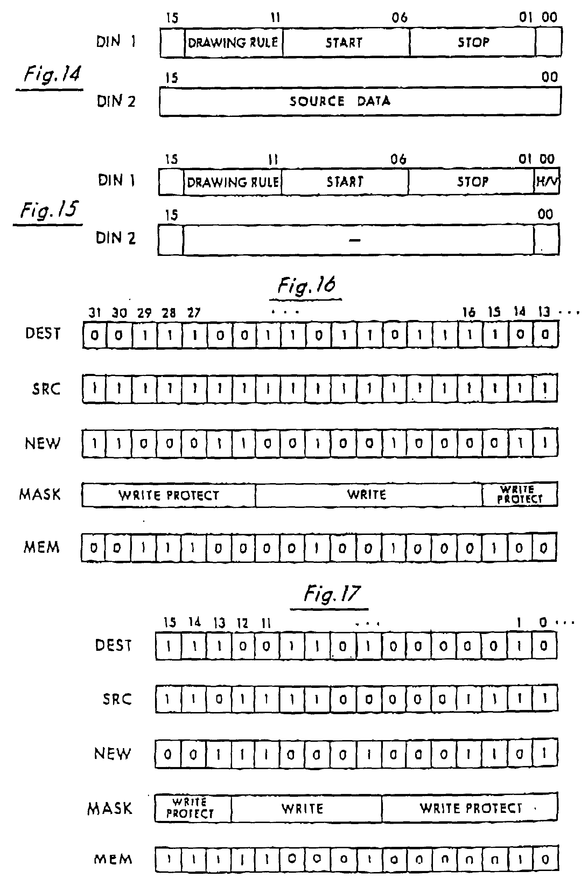

The operation of this table will be discussed in the following. In addition, the present invention incorporates two data cycles termed DIN1 and DIN2. In Figure 14, DIN1 and DIN2 are shown for the image mode of operation. Figure 15 shows DIN1 and DIN2 for the vector mode of operation.

Under the teachings of the present invention, the drawing rule function is incorporated directly in the dynamic (video) RAM chip 10. This permits faster modification of data within the memory block 1300. Conventional video RAM designs require that the information in the memory block be read out of the video RAM chip and be modified in another chip or circuit. After modification off the chip, it is rewritten back into the memory block. This is a slow process.

Under the teachings of the present invention up to 32 pixel elements can be changed in one operation. Conventional approaches use the image mode of operation whereas the present invention also incorporates the vector mode of operation wherein a horizontal or vertical vector in a defined page can be modified and changed according to the selected drawing rule. This feature significantly speeds up the time for modification of the information contained in the memory block. For example, if under a conventional approach, a vertical line from screen 200 is to be modified, a number of horizontal scan lines would have to be read out of the memory in order to modify the one bit corresponding to the vertical line. Under the teachings of the present invention, only one vertical vector would have to be accessed and modified significently increasing the performance of the system over conventional approaches. It is estimated that current video RAM systems can process these vectors at the rate of 300,000 to 700,000 vectors per second. Under the teachings of the present invention, three to four million horizontal and vertical vectors per second can be processed.

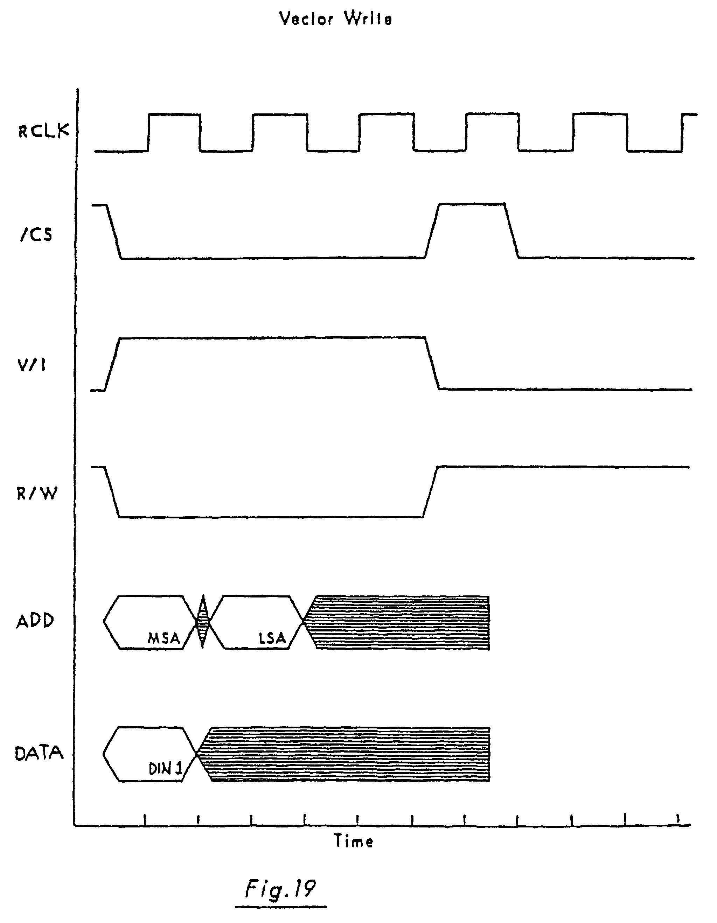

The speed up is due to the provision of the vector write mode of operation as will be discussed in the following. In the vector write mode of operation, the MSA and LSA addresses of Figure 8 are sequentially loaded into the address register 1320. This is shown in the timing diagram of Figure 19 where the /CS selects the proper chip, the V/I lead is high to select the vector mode, and R/W is low for write. Hence, the MSA and LSA of the address (Figure 8) are loaded into the address register 1320 as well as the drawing rule, start, and stop (Figure 15) over the random port data bus 90 into the data register 1340. The vector address (MSA and LSA) and the data (DIN1) is delivered during a first time interval.

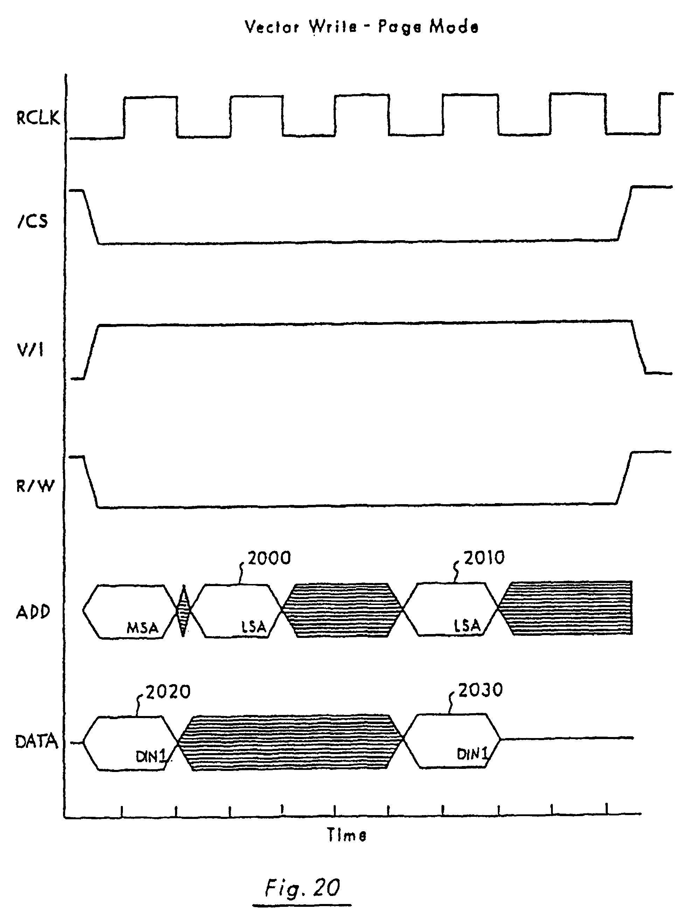

In Figure 20, the timing for vector write, page mode is shown. Here, the MSA remains the same whereas the LSA and the DIN are changed at times 2000 and 2010 for the LSA and time 2020 and 2030 for the DIN1. The MSA and LSA addresses containing the page row, page column and vector identification of Figure 8 are stored into the address register 1320. Eight bit outputs are delivered over lines 1322 to address the memory row of memory block 1300, five of the bits are delivered over lines 1324 to address the memory column of memory block 1300, and the three remaining bits are delivered over lines 1326 to the block decode circuitry 1330. The block decode circuitry 1330 is simply a one out of eight decode to selectively activate one of the eight memory blocks 1300.

In the vector mode of operation, DIN1 as shown in Figure 15 is read into the data register 1340 over data bus 90. DIN2 is not used in this mode. The five START bits are delivered over lines 1344 to the write mask 1336 and the five STOP bits are delivered over lines 1346 to the write mask 1336. The four drawing rule bits are delivered over lines 1350 to the drawing rule circuit 1354. The H/V bit is delivered from the data register 1340 over line 1342 to the memory block 1300.

The address register is of conventional register design that enables data to be read from a bus and to store the information in the register. The address register is enabled to read the most significant address by the MSA enable and the least significant address by the LSA enable. Likewise, the data register 1340 is of conventional design and reads in data from the data bus 90 and stores it internally upon being selectively enabled by the DIN1 and DIN2 enable lines. At this point and time, the address register 1320 and the data register 1340 have the necessary vector information to identify either a horizontal or vertical vector to perform a drawing rule operation on it. Other circuits could be designed to perform the above described address and data functions.

In reference back to Figures 5-8, it is seen that a selected vertical 600 or horizontal 610 vector is composed of 32 pixel elements or when resident in the memory block 1300, 32 memory cells. The START and STOP information conveys the precise portion of the vector to be modified according to the drawing rule. For example, if the desired place to start the modification within a vector is seven bits from the start of the vector, the START command would be 00111 and if the STOP location is the fifteenth bit, the STOP command would be 01111. The START and STOP information is delivered to the write mask which provides 32 possible write protect WP signals over lines 1348. Hence, in our example of starting at location 7 and stopping at location 15 in a 32 bit vector, the first seven bits would be activated in the write protect mode and the last sixteen bits would be activated in the write protect mode so that when NEW data is read back into memory over lines 1356 only the desired portion of memory cells between the START and STOP locations are written into the memory.

In Figure 16 is shown an example of performing a drawing rule operation in the vector write page mode. The address register 1320 addresses a specific horizontal or vertical vector in the memory block 1300. Whether or not the vector is horizontal or vertical is determined by the H/V signal on line 1342 which is the first bit in DIN1 of Figure 15. The OLD information is read out of the memory block on line 1358 and in Figure 16 is designated DEST for "destination". It is to be noted that information could be delivered through the output control 1338 to data bus 90 for delivery back into the system if desired or into the destination latch 1360. The appropriate enable signal DEST on line 1364 enables the destination latch 1360 to read in the OLD information.

All 32 bits of the destination information of Figure 16 are read into the latch 1360. The output 1362 of the destination latch 1360 is delivered as the destination input to the drawing rule circuit 1354. For vector mode operation, the SOURCE (SRC) signals on lines 1352 from the data register 1340 are set to all ones and are shown in Figure 16. The drawing rules are set forth in TABLE III.

In the example of Figure 16, the "not destination" drawing rule 1010 appears in the data register 1340. Hence, the OLD information or destination data DEST is inverted to result in a new modified vector which is termed NEW as shown in Figure 16. However, the writing of this information inlo the memory block occurs under control of the write mask 1336 and as previously explained, for our example, bits 31-26 and 15-0 are write protected. Only bits 25-16 of the NEW data can be written into memory. In a similar fashion, all of the logical functions of the drawings rules can be implemented for the entire vector or a portion thereof based upon the START and STOP information.

In the vector mode of operation, up to 32 pixel elements stored in memory block 1300 can be changed in one operation on chip. The present invention is capable of changing a vector located either horizontally or vertically as shown in Figure 6 through use of the H/V bit.

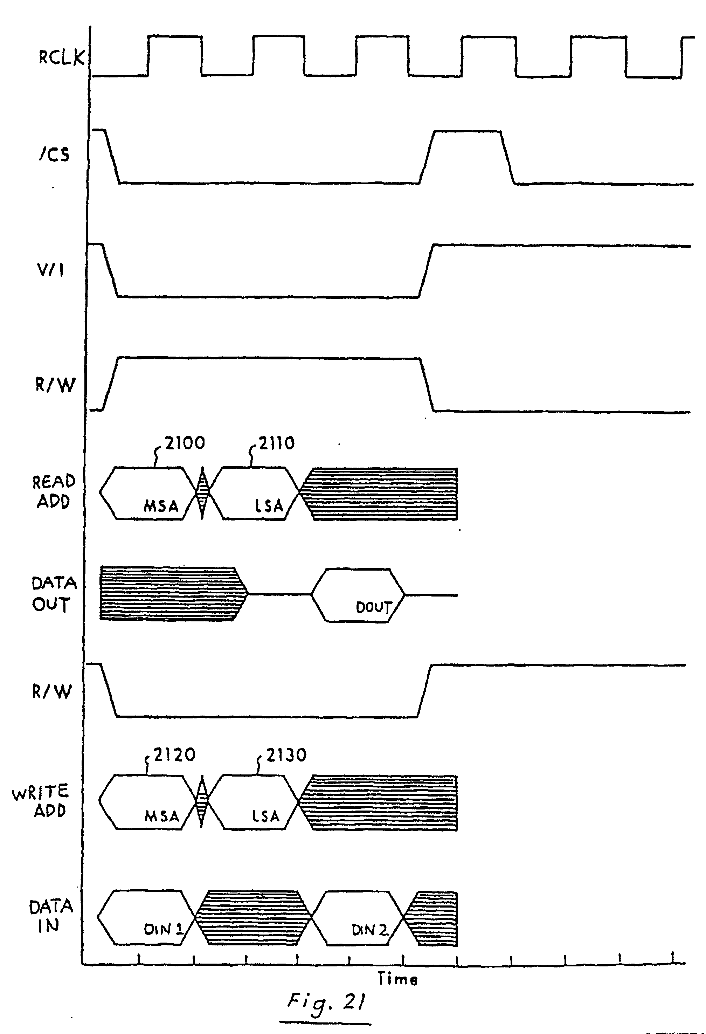

In the image mode of operation, the MSA and LSA addresses of Figure 11 are utilized. In Figure 21, the timing for both image read and image write is shown. Again /CS is properly enabled, and V/I is set low for the image mode. When R/W is set high for read, the read address (MSA 2100 and LSA 2110) is delivered over bus 100 and the data DOUT is read out over bus 90. When R/W is set low for write, the write address (MSA 2120 and LSA 2130) is delivered over bus 100 and the data DIN1 + DIN2 is delivered to the chip over bus 90. Here, the address and DIN1 (i.e., drawing rule and START/STOP) are delivered during the first time interval and DIN2 (i.e., source data) is delivered during the second time interval.

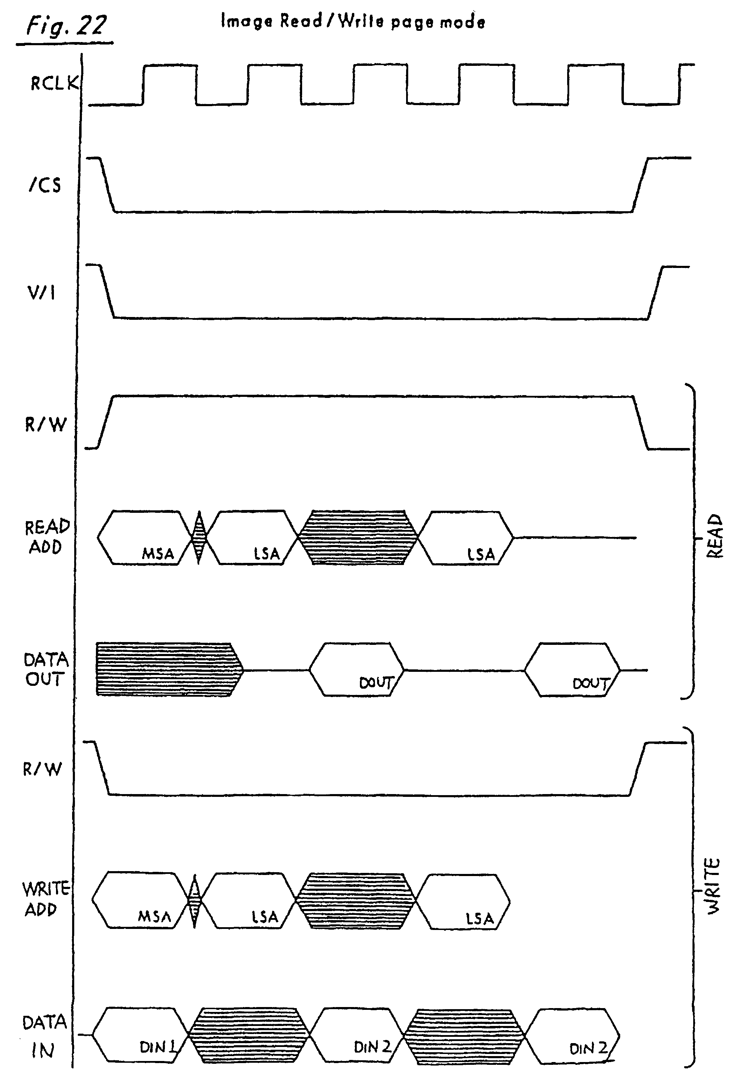

Figure 22 shows the timing for the image read 15 and write in the page mode. In the page mode, the LSA portion of the address changes. Hence, when reading, the changing of LSA causes new data DOUT to be read out. When writing R/W is low, new data is delivered right after delivery of the LSA.

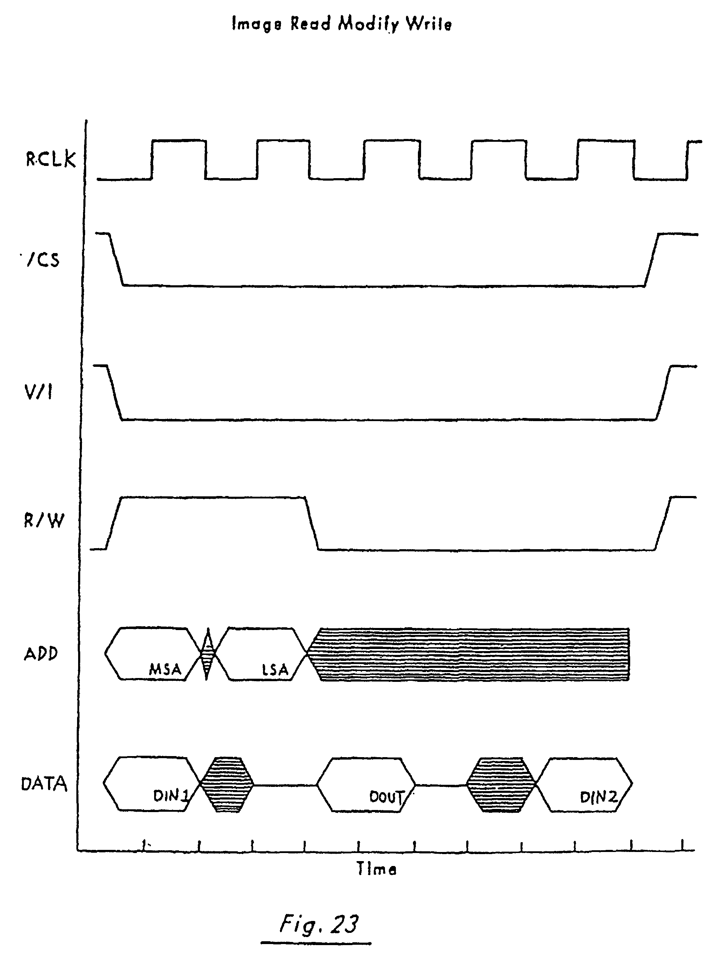

Finally, Figure 23 shows the timing for image read modify write wherein DIN1 of Figure 14 delivers the start, stop and drawing rule, DOUT is the data at the addressed location and DIN2 is the SOURCE data to be read into the chips. As before, the MSA and LSA are read inlo the address register 1320 and the corresponding DIN1 and DIN2 data configurations in Figure 14 are read into the data register 1340. In image mode of operation, a 16 bit word from a scan line is read from the memory block 1300 and is delivered into the destination latch 1360.

In Figure 17 is an example of a word called DEST read as OLD information from the memory block 1300. In the image mode operation, source data is delivered on DIN2 as shown in Figure 14 and designated SRC. Figure 17 shows an example of source data. This 16 bit source data SRC is delivered over lines 1352 into the drawing rule circuit 1354. If a drawing rule such as "exclusive-or" (DR = 0110) is utilized, circuit 1354 outputs on leads 1356 the NEW word as shown in Figure 17. Again, the image mode of operation can have a START and STOP location within the word and for masking purposes. In the example assume START equals 0011 and STOP equals 1000. Hence, the mask circuit 1336 provides write protect WP for the bits indicated as in MASK in Figure 17. What is written into memory is shown as NEW in Figure 17. The present invention is capable of performing drawing rule operations on chip in the image mode of operation.

As discussed above and as shown in Figure 23, the present invention delivers the drawing rule to integrated circuit chip with the delivery of the address during the same time interval and concurrently with the address cycle. This provides a significant speed up over the Hitachi approach which requires a separate time interval in which to deliver the drawing rule.

In the serial data transfer mode of operation, the MSA and LSA addresses of Figure 4 are utilized and read into the address register 1320. As set forth in TABLE II above, there are no corresponding DIN1 or DIN2 data words. When these MSA and LSA address words are read in, the appropriate scan line and scan line portion are read from the memory block 1300 into the the dynamic latch 1304 as previously discussed.

The random state machine 1366 is of conventional design and based upon the incoming set of control enables (i.e., V/I, R/W, RFRSH, and /CS) delivers, according to the pulses of the single clock RCLK, the following internal random port enable pulses:(1) EN-MSA and CLK-LSA to enable the reading of the most significant and least significant addresses on address bus 100 into the address register 1320, (2) CLK-DIN1 and EN-DIN2 to read in the data appearing on bus 90 into the data register 1340, (3) DEST to enable the destination latch 1360, (4) PRECH to precharge each of the memory blocks 1300 in a conventional fashion, (5) EN-DL to enable the dynamic latch 1304 to read in data from the memory block 1300, (6) /WE to enable the WRITE mask 1336 to write protect the memory block 1300 based upon the START and STOP information, (7) ALL to access all of the memory blocks rather than a particular block as specified by the block select portion of the address (this is asserted during all regular and serial data transfer cycles), and (8) the OE signal which enables the output control 1338 to output data onto the data bus 90. While the preferred embodiment uses these internal enables other enables could be used in variations on this approach.

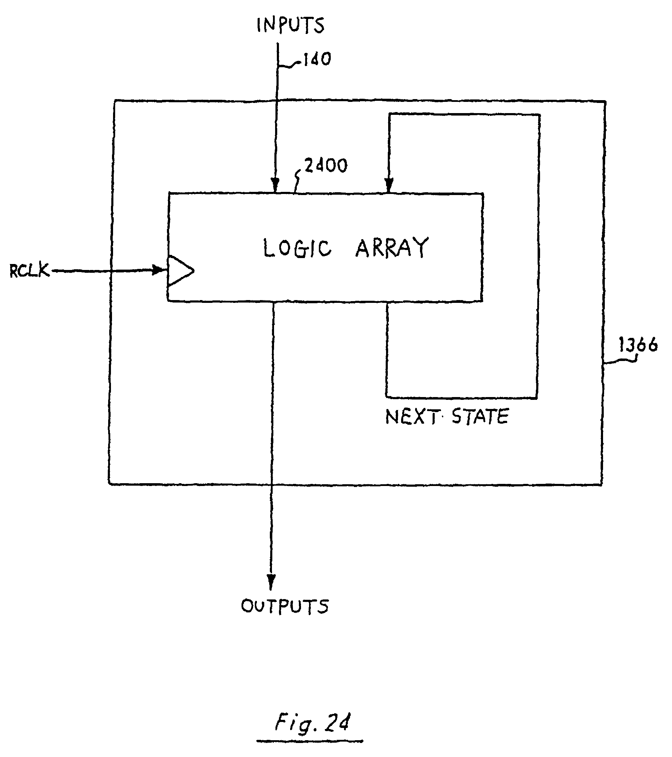

The random port state machine 1360 can comprise, for example, a programmable logic array shown in Figure 24 wherein the inputs 140 (i.e., a set of control enables) based upon the use of only a single clock RCLK to generate the outputs set forth above. Internal to the random state machine 1366 is a next state for the logic array 2400. The next state table 5 is set forth as Table IV.

**TABLE IV**

| Input 3210 | State 3210 | Next State 3210 | Input 3210 | State 3210 | Next State 3210 | Input 3210 | State 3210 | Next State 3210 |
|---|---|---|---|---|---|---|---|---|
| 00xx | 0000 | 0100 | 0101 | 0000 | 1000 | 0111 | 0000 | 0001 |
| 00xx | 0001 | xxxx | 0101 | 0001 | xxxx | 0111 | 0001 | 0011 |
| 00xx | 0010 | xxxx | 0101 | 0010 | xxxx | 0111 | 0010 | 0000 |
| 00xx | 0011 | xxxx | 0101 | 0011 | xxxx | 0111 | 0011 | 0010 |
| 00xx | 0100 | 0110 | 0101 | 0100 | xxxx | 0111 | 0100 | xxxx |
| 00xx | 0101 | xxxx | 0101 | 0101 | xxxx | 0111 | 0101 | xxxx |
| 00xx | 0110 | 0111 | 0101 | 0110 | xxxx | 0111 | 0110 | xxxx |
| 00xx | 0111 | 0000 | 0101 | 0111 | xxxx | 0111 | 0111 | xxxx |
| 00xx | 1000 | xxxx | 0101 | 1000 | 1100 | 0111 | 1000 | xxxx |
| 00xx | 1001 | xxxx | 0101 | 1001 | 1011 | 0111 | 1001 | xxxx |
| 00xx | 1010 | xxxx | 0101 | 1010 | xxxx | 0111 | 1010 | xxxx |
| 00xx | 1011 | xxxx | 0101 | 1011 | 1100 | 0111 | 1011 | xxxx |
| 00xx | 1100 | xxxx | 0101 | 1100 | 1101 | 0111 | 1100 | xxxx |
| 00xx | 1101 | xxxx | 0101 | 1101 | 1100 | 0111 | 1101 | xxxx |
| 00xx | 1110 | xxxx | 0101 | 1110 | xxxx | 0111 | 1110 | xxxx |
| 00xx | 1111 | xxxx | 0101 | 1111 | 1011 | 0111 | 1111 | xxxx |
| | | | | | | | | |
| 0100 | 0000 | 1000 | 0110 | 0000 | 1000 | 1xxx | 0000 | 0000 |
| 0100 | 0001 | xxxx | 0110 | 0001 | xxxx | 1xxx | 0001 | 0000 |
| 0100 | 0010 | xxxx | 0110 | 0010 | xxxx | 1xxx | 0010 | 0000 |
| 0100 | 0011 | xxxx | 0110 | 0011 | xxxx | 1xxx | 0011 | 0000 |
| 0100 | 0100 | xxxx | 0110 | 0100 | xxxx | 1xxx | 0100 | 0000 |
| 0100 | 0101 | xxxx | 0110 | 0101 | xxxx | 1xxx | 0101 | 0000 |
| 0100 | 0110 | xxxx | 0110 | 0110 | xxxx | 1xxx | 0110 | 0000 |
| 0100 | 0111 | xxxx | 0110 | 0111 | xxxx | 1xxx | 0111 | 0000 |
| 0100 | 1000 | 1001 | 0110 | 1000 | 1001 | 1xxx | 1000 | 0000 |
| 0100 | 1001 | 1011 | 0110 | 1001 | 1011 | 1xxx | 1001 | 0000 |
| 0100 | 1010 | xxxx | 0110 | 1010 | xxxx | 1xxx | 1010 | 0000 |
| 0100 | 1011 | 1001 | 0110 | 1011 | 1111 | 1xxx | 1011 | 0000 |
| 0100 | 1100 | 1101 | 0110 | 1100 | 1101 | 1xxx | 1100 | 0000 |
| 0100 | 1101 | 1001 | 0110 | 1101 | 1001 | 1xxx | 1101 | 0000 |
| 0100 | 1110 | xxxx | 0110 | 1110 | xxxx | 1xxx | 1110 | 0000 |
| 0100 | 1111 | 1011 | 0110 | 1111 | 1011 | 1xxx | 1111 | 0000 |
| Input₃ N_CS | | | | | | | | |
| Input₂ N_RFRSH | | | | | | | | |
| Input₁ V_I | | | | | | | | |
| Input₀ R_W | | | | | | | | |

In Table IV the input set format is: /CS, RFRSH, V/I, and R/W. As can be seen above for each different set of enables (INPUT) from the control bus 140, the random state machine produces a predetermined sequence as derived from the clock (RCLK) signal of the state table (STATE) to produce the control pulses which are defined next.

The output STATE signals are decoded from the state and are set forth in Table V.

**TABLE V**

| | Output | | | | | | | | | | |
|---|---|---|---|---|---|---|---|---|---|---|---|
| State 3210 | 10 | 9 | 8 | 7 | 6 | 5 | 4 | 3 | 2 | 1 | 0 |
| 0000 | 1 | 1 | x | 0 | x | x | 1 | 1 | 0 | 1 | 0 |
| 0001 | 0 | 0 | 0 | x | x | x | 1 | 1 | 1 | 1 | 0 |
| 0010 | 0 | 0 | x | x | x | x | 1 | 1 | 1 | 1 | 0 |
| 0011 | 0 | 0 | 1 | x | x | x | 1 | 1 | 1 | 1 | 1 |
| | | | | | | | | | | | |
| 0100 | 0 | x | x | x | x | x | 1 | 1 | 1 | 0 | 0 |
| 0101 | x | x | x | x | x | x | x | 1 | x | x | x |
| 0110 | 0 | x | x | x | x | x | 1 | 1 | 1 | 0 | 0 |
| 0111 | 0 | x | x | x | x | x | 1 | 1 | 1 | 0 | 0 |
| | | | | | | | | | | | |
| 1000 | 0 | 0 | 0 | 1 | x | x | 1 | 1 | 0 | 1 | 0 |
| 1001 | 0 | 0 | 1 | 0 | 1 | 1 | 1 | 1 | 0 | 1 | 0 |
| 1010 | x | x | x | x | x | x | x | 1 | x | x | x |
| 1011 | 0 | 0 | 0 | 0 | 0 | 0 | 0 | 1 | 0 | 1 | 0 |
| | | | | | | | | | | | |
| 1100 | 0 | 0 | 1 | 0 | x | x | 1 | 0 | 0 | 1 | 0 |
| 1101 | 0 | 0 | 0 | 0 | x | x | 1 | 1 | 0 | 1 | 0 |
| 1110 | x | x | x | x | x | x | x | 1 | x | x | x |
| 1111 | 0 | 0 | 1 | 1 | x | 1 | 1 | 1 | 0 | 1 | 0 |

The output relationships are set forth in Table VI.

**TABLE VI**

| Output₁₀ | PRECHARG |
|---|---|
| Output₉ | EN_MSA |
| Output₈ | CLK_LSA |
| Output₇ | CLK_DIN1 |
| Output₆ | EN_DIN2 |
| Output₅ | EN_DEST |
| Output₄ | N_WE |
| Output₃ | N_OE |
| Output₂ | ALL |
| Output₁ | N_IRFRSH |
| Output₀ | EN_DL |

The random port control signals set forth in Table VI become valid in the random port 1200, as shown in Figures 18 through 23 with the edges of the clock RCLK.

It can clearly be seen based upon this disclosure that only a single clock pulse RCLK controls the random port 1200 of the present invention. In other words, the random port 1200 of the present invention receives a set of control signals (i.e., INPUT of Table IV). Each set corresponding to a different mode of operation for the random port. The random state machine 1366 provides the sequential configuration (i.e., STATE and NEXT STATE of Table IV) for the received set. Each different set has a different sequential configuration resulting in its own predetermined sequence of internal control pulses (i.e., Table V). The single random port clock provides the timing signal necessary for executing the configured sequence of internal control pulses so that the random port operates in the mode of operation corresponding to the received set of control signals. It is to be expressly understood that while a preferred approach is set forth in Tables IV, V, and VI that other configurations of control signals and states can be defined under the teachings of the present invention to work on the provision of a single random port clock which in the present embodiment is 16.7 MHz.

Combining the aforesaid state tables with the timing diagrams of Figures 19 through 23, the method of modifying the stored information in the memory is based upon a series of time intervals which are derived from the single random clock RCLK. During a first time interval, the vector or image address as well as the drawing rule and the START and STOP locations are delivered to the chip. Based upon the set of control enables, the RCLK then sequences through the appropriate state table. Hence, during a second time interval, the addressed information is delivered from memory and the source data is delivered to the chip. During a third interval, the delivered information (i.e., DEST in Figures 16 and 17) is modified with the source data (i.e., SRC of Figures 16 and 17) based upon the drawing rule (i.e., Table III). During a fourth time interval, the modified information (i.e., NEW of Figures 16 and 17) is written between the START and STOP bit locations (i.e., MASK of Figures 16 and 17) into memory. Variations to this method are possible under the teachings of the present invention.

It is to be expressly understood that the preferred embodiment illustrates certain bit fields and patterns, certain pin configurations and layouts; however, the present invention is not so limited thereto so that under the teachings of the present invention other embodiments could be used.

While preferred embodiments of the present invention have been shown, it is to be expressly understood that modifications and changes may be made thereto and that the present invention is set forth in the following claims.

It is understood that various other modifications will be apparent to and can be readily made by those skilled in the art without departing from the scope of this invention. Accordingly, it is not intended that the scope of the claims appended hereto be limited to the description as set forth herein.

## Claims

1. A synchronous dynamic random access memory integrated circuit (SDRAMIC) comprising:
a) a memory block (1300) including a plurality of memory cells for storing information;
b) an input (1200) for receiving an external clock signal (RCLK);
c) address input means (1320) for receiving an address (MSA, LSA) defining a location of information stored in said memory block (1300); and
d) control means (1366) for receiving a predetermined set of control signals (/CS, RFRSH, R/W, V/I) provided from outside of said SDRAMIC, for making a transition from a state to a next state in accordance with said predetermined set of control signals (/CS, RFRSH, R/W, V/I) on respective edges of said external clock signal (RCLK) and for outputting an internal control signal (EN_MSA, CLK_LSA, CLK_DIN1,..., ALL, OE) defining a timing of an internal operation of said SDRAMIC based on said next state,
e) said predetermined set of control signals (/CS, RFRSH, R/W, V/I) include a first control signal (R/W) and a second control signal (/CS), said internal operation represents a write operation when said first control signal (R/W) is in a first logic level (low) and said second control signal (/CS) is in a second logic level, and said internal operation represents a read operation when said first control signal (R/W) is in a third logic level (high) which is different from said first logic level (high) and said second control signal (/CS) is in said second logic level;
**characterized by**
f) said address input means (1320) receiving said address as a first address (MSA) and a second address (LSA), said address input means (1320) providing said first address (MSA) as an output in response to a first edge of said external clock signal (RCLK), said address input means (1320) providing said second address (LSA) as an output in response to a second edge of said external clock signal (RCLK), said first edge of said external clock signal (RCLK) being different from said second edge of said external clock signal (RCLK); and
g) access means (1340, 1338, 1336) being provided for accessing a location in said memory block (1300) corresponding to said first address (MSA) and said second address (LSA) provided by said address input means (1320).

2. The SDRAMIC of claim 1, **characterized in that**
a logic level of said first control signal (R/W) is changed during a period when said second control signal (/CS) is in said second logic level, and
said operation of said SDRAMIC is changed between said read operation and said write operation in accordance with said logic level change of said first control signal (R/W) without reverting back to a state prior to starting either said read operation or said write operation.

3. The SDRAMIC of claim 1, **characterized in that**
said access means (1340, 1338, 1336) comprises output means (1338) for outputting information stored at said location of said memory block (1300) in response to a third edge of said external clock signal (RCLK).

4. The SDRAMIC of claim 3, **characterized in that**
said control means (1366) supplies a first enable signal (EN_MSA) and a second enable signal (GLK_LSA) to said address input means (1320) in response to said predetermined set of control signals (/CS, RFRSH, R/W, V/I) on an edge of said external clock signal (RCLK), and supplies an output enable signal (OE) to said output means (1338) in response to said predetermined set of control signals (/CS, RFRSH, R/W, V/I) on an edge of said external clock signal (RCLK),
each of said first enable signal (EN_MSA), said second enable signal (GLK_LSA) and said output enable signal (OE) being synchronous with an edge of said external clock signal (RCLK),
wherein said address input means (1320) provides said first address (MSA) in response to said first enable signal (EN_MSA), said address input means (1320) provides said second address (LSA) in response to said second enable signal (CLK_LSA), and said output means outputs said information in response to said output enable signal (OE).

5. The SDRAMIC of claim 1, **characterized in that** said access means (1340, 1338, 1336) comprises:
data input means (1340) for receiving data, said data input means (1340) providing said data as an output in response to a third edge of said external clock signal (RCLK); and
write means (1336) for writing said data to said memory block (1300) at a location corresponding to said first address (MSA) and said second address (LSA) in response to a fourth edge of said external clock signal (RCLK).

6. The SDRAMIC of claim 5, **characterized in that**
said control means (1366) supplies a data enable signal (CLK-DIN1, EN_DIN2) to said data input means (1340) in response to said predetermined set of control signals (/CS, RFRSH, R/W, V/I) on an edge of said external clock signal (RCLK), and supplies a write enable signal (WE) to said write means (1336) in response to said predetermined set of control signals (/CS, RFRSH, R/W, V/I) on an edge of said external clock signal (RCLK), each of said data enable signal and said write enable signal being synchronous with an edge of said external clock signal (RCLK),
wherein said data input means (1340) provides said data in response to said data enable signal, and said write means (1336) writes said data in response to said write enable signal.

7. The SDRAMIC of claim 1, further comprising:
a serial port (1210), including:
means (1314) for receiving a serial port clock signal (SCLK) for controlling timing of said serial port (1210);
serial output means (1306); and
transfer means (1304) for transferring serial information stored in said memory block (1300) to said serial output means (1306) in response to a third edge of said external clock signal (RCLK);
wherein said serial output means (1306) sequentially outputs portions of said serial information in response to respective edges of said serial port clock signal (SCLK).

8. The SDRAMIC of claim 7, **characterized in that**
said control means (1366) supplies a first enable signal (EN_MSA) and a second enable signal (CLK_LSA) to said address input means (1320) in response to said predetermined set of control signals (/CS, RFRSH, R/W, V/I) on an edge of said external clock signal (RCLK), and supplies a transfer enable signal (EN_DL) to said transfer means (1304) in response to said predetermined set of control signals (/CS, RFRSH, R/W, V/I) on an edge of said external clock signal (RCLK),
each of said first enable signal (EN_MSA), said second enable signal (CLK_LSA) and said transfer enable signal (EN_DL) being synchronous with an edge of said external clock signal (RCLK),
wherein said address input means (1320) provides said first address (MSA) in response to said first enable signal (EN_MSA), said address input means (1320) provides said second address (LSA) in response to said second enable signal (CLK_LSA), and said transfer means (1304) transfers said serial information in response to said transfer enable signal (EN_DL).

9. The SDRAMIC of claim 1, **characterized in that** a period in which said logic level of said first control signal (R/W) is changed is included in one clock cycle of said external clock signal (RCLK).

10. The SDRAMIC of claim 9, **characterized in that** said first address (MSA) is maintained before and after said logic level change of said first control signal (R/W).

11. The SDRAMIC of claim 1, **characterized in that** a period in which said logic level of said second control signal (/CS) is changed is included in one clock cycle of said external clock signal (RCLK).

12. A method for accessing a memory in a synchronous dynamic random access memory integrated circuit (SDRAMIC), the SDRAMIC comprising:
a) a memory block (1300) including a plurality of memory cells for storing information;
b) an input (1200) for receiving an external clock signal (RCLK);
c) address input means (1320) for receiving an address (MSA, LSA) defining a location of information stored in said memory block (1300); and
d) control means (1366) for receiving a predetermined set of control signals (/CS, RFRSH, R/W, V/I) provided from outside of said SDRAMIC, for making a transition from a state to a next state in accordance with said predetermined set of control signals (/CS, RFRSH, R/W, V/I) on respective edges of said external clock signal (RCLK), and for outputting an internal control signal (EN_MSA, CLK_LSA, CLK_DIN1, ..., ALL, OE) defining a timing of an internal operation of said SDRAMIC based on said next state,
e) said predetermined set of control signals (/CS, RFRSH, R/W, V/I) include a first control signal (R/W) and a second control signal (/CS), said internal operation represents a write operation when said first control signal (R/W) is in a first logic level (low) and said second control signal (/CS) is in a second logic level, and said internal operation represents a read operation when said first control signal (R/W) is in a third logic level (high) which is different from said first logic level and said second control signal (/CS) is in said second logic level;
**characterized by**
f) said address input means (1320) receiving said address as a first address (MSA) and a second address (LSA), said address input means (1320) providing said first address (MSA) as an output in response to a first edge of said external clock signal (RCLK) and providing said second address (LSA) as an output in response to a second edge of said external clock signal (RCLK), said first edge of said external clock signal (RCLK) being different from said second edge of said external clock signal (RCLK); and
g) accessing a location in said memory block (1300) corresponding to said first address (MSA) and said second address (LSA) provided by said address input means (1320).

13. A system with a synchronous dynamic random access memory integrated circuit (SDRAMIC), comprising:
a) a circuit for accessing said SDRAMIC, and a bus (90, 100, 140) connecting said circuit to said SDRAMIC;
said circuit comprising:
b) means (110) for providing an address (MSA, LSA) on said bus (90, 100, 140), said address defining a location of information stored in said memory block (1300), and means (120) for providing a predetermined set of control signals (/CS, RFRSH, R/W, V/I) on said bus (90, 100, 140), said predetermined set of control signals (/CS, RFRSH, V/I, R/W) being valid on said bus (90, 100, 140) on an edge of a clock signal (RCLK);
said SDRAMIC comprising:
c) a memory block (1300) including a plurality of memory cells for storing information;
d) an input (1200) for receiving said clock signal (RCLK);
e) address input means (1320) for receiving said address (MSA, LSA) through said bus (90, 100, 140), and
f) control means (1366) for receiving said predetermined set of control signals (/CS, RFRSH, R/W, V/I) through said bus (90, 100, 140), for making a transition from a state to a next state in accordance with said predetermined set of control signals (/CS, RFRSH, R/W, V/I) on respective edges of said clock signal (RCLK), and for outputting an internal control signal (EN_MSA, CLK_LSA, CLK_DIN1, ..., ALL, OE) defining a timing of an internal operation of said SDRAMIC based on said next state,
g) said predetermined set of control signals (/CS, RFRSH, R/W, V/I) include a first control signal (R/W) and a second control signal (/CS), said internal operation represents a write operation when said first control signal (R/W) is in a first logic level (low) and said second control signal (/CS) is in a second logic level, and said internal operation represents a read operation when said first control signal (R/W) is in a third logic level (high) which is different from said first logic level and said second control signal (/CS) is in said second logic level;
**characterized by**
h) said address input means (1320) receiving said address as a first address (MSA) and a second address (LSA), said first address (MSA) being valid on said bus (90, 100, 140) on a first edge of a clock signal (RCLK) and said second address (LSA) being valid on said bus (90, 100, 140) on a second edge of said clock signal (RCLK), said address input means (1320) providing said first address (MSA) as an output in response to said first edge of said clock signal (RCLK), said address input means (1320) providing said second address (LSA) as an output in response to said second edge of said clock signal (RCLK), said first edge of said clock signal (RCLK) being different from said second edge of said clock signal (RCLK); and
i) said SDRAMIC furthermore comprising access means (1340, 1338, 1336) for accessing a location in said memory block (1300) corresponding to said first address (MSA) and said second address (LSA) provided by said address input means (1320).

14. The system of claim 13, **characterized in that** said access means (1340, 1338, 1336) comprises output means (1338) for outputting information stored at said location of said memory block (1300) in response to a third edge of said clock signal (RCLK).

15. The system of claim 14, **characterized in that**
said control means (1366) supplies a first enable signal (EN_MSA) and a second enable signal (CLK_LSA) to said address input means (1320) in response to said predetermined set of control signals (/CS, RFRSH, R/W, V/I) on an edge of said clock signal (RCLK), and supplies an output enable signal (OE) to said output means (1338) in response to said predetermined set of control signals (/CS, RFRSH, R/W, V/I) on an edge of said clock signal (RCLK),
each of said first enable signal (EN_MSA), said second enable signal (CLK_LSA) and said output enable signal (OE) being synchronous with an edge of said clock signal (RCLK),
wherein said address input means (1320) provides said first address (MSA) in response to said first enable signal (EN_MSA), said address input means (1320) provides said second address (LSA) in response to said second enable signal (CLK_LSA), and said output means (1338) outputs said information in response to said output enable signal (OE).

16. The system of claim 13, **characterized in that**
said circuit for accessing said SDRAMIC further comprises means (110) for providing data on said bus (90, 100, 140), said data being valid on said bus (90, 100, 140) on a third edge of said clock signal (RCLK), and
said access means (1340, 1338, 1336) comprises:
data input means (1340) for receiving said data through said bus (90, 100, 140), said data input means (1340) providing said data as an output in response to said third edge of said clock signal (RCLK); and
write means (1336) for writing said data to said memory block (1300) at a location corresponding to said first address (MSA) and said second address (LSA) in response to a fourth edge of said clock signal (RCLK).

17. The system of claim 16, **characterized in that**
said control means (1366) supplies a data enable signal (CLK_DIN1, EN_DIN2) to said data input means (1340) in response to said predetermined set of control signals (/CS, RFRSH, R/W, V/I) on an edge of said clock signal (RCLK), and supplies a write enable signal (WE) to said write means (1336) in response to said predetermined set of control signals (/CS, RFRSH, R/W, V/I) on an edge of said clock signal (RCLK), each of said data enable signal and said write enable signal being synchronous with an edge of said clock signal (RCLK),
wherein said data input means (1340) provides said data in response to said data enable signal, and said write means (1336) writes said data in response to said write enable signal.

18. The system of claim 13, **characterized in that** said bus includes an address bus (100) for conveying said first address (MSA) and said second address (LSA) and a data bus (90) for conveying data.

## Patentansprüche

1. Integrierter Schaltkreis mit synchronem dynamischem Speicher mit wahlfreiem Zugriff (SDRAMIC) mit :
a) einem Speicherblock (1300) umfassend eine Mehrzahl von Speicherzellen zum Speichern einer Information;
b) einer Eingabe (1200) zum Empfangen eines externen Taktsignals (RCLK);
c) einer Adresseneingabevorrichtung (1320) zum Empfangen einer Adresse (MSA, LSA), welche eine Stelle einer Information definiert, welche in dem Speicherblock (1300) gespeichert ist; und
d) einer Steuervorrichtung (1366) zum Empfangen eines vorgegebenen Satzes von Steuersignalen (/CS, RFRSH, R/W, V/I), welche von außerhalb des SDRAMIC zur Verfügung gestellt werden, zur Durchführung eines Übergangs von einem Zustand zu einem nächsten Zustand gemäß dem vorgegebenen Satz von Steuersignalen (/CS, RFRSH, R/W, V/I) bei den jeweiligen Flanken des externen Taktsignals (RCLK) und zum Ausgeben eines internen Steuersignals (EN_MSA, CLK_LSA, CLK_DIN1,...., ALL, OE), welche einen Zeitablauf einer internen Arbeitsweise des SDRAMIC definieren, basierend auf dem nächsten Zustand,
e) wobei der vorgegebene Satz der Steuersignale (/CS, RFRSH, R/W, V/I) ein erstes Steuersignal (R/W) und ein zweites Steuersignal (/CS) enthält, wobei die interne Arbeitsweise einen Schreibvorgang darstellt, wenn das erste Steuersignal (R/W) in einem ersten logischen Pegel (niedrig bzw. low) ist und das zweite Steuersignal (/CS) in einem zweiten logischen Pegel ist, und die interne Arbeitsweise stellt einen Lesevorgang dar, wenn das erste Steuersignal (R/W) in einem dritten logischen Pegel (hoch bzw. high) ist, welcher von dem ersten logischen Pegel (high) verschieden ist und das zweite Steuersignal (/CS) ist in bzw. bei dem zweiten logischen Pegel;
**gekennzeichnet durch**
f) die Adresseneingabevorrichtung (1320) empfängt die Adresse als eine erste Adresse (MSA) und eine zweite Adresse (LSA), die Adresseneingabevorrichtung (1320) stellt die erste Adresse (MSA) als eine Ausgabe in Reaktion auf eine erste Flanke des externen Taktsignals (RCLK) zur Verfügung, die Adresseneingabevorrichtung (1320) stellt die zweite Adresse (LSA) als eine Ausgabe in Reaktion auf eine zweite Flanke des externen Taktsignals (RCLK) zur Verfügung, die erste Flanke des externen Taktsignals (RCLK) ist von der zweiten Flanke des externen Taktsignals (RCLK) verschieden; und
g) eine Zugriffsvorrichtung (1340, 1338, 1336) ist vorgesehen zum Zugreifen auf eine Stelle in dem Speicherblock (1300) entsprechend der ersten Adresse (MSA) und der zweiten Adresse (LSA), welche von der Adresseneingabevorrichtung (1320) zur Verfügung gestellt wird.

2. SDRAMIC nach Anspruch 1, **dadurch gekennzeichnet, dass**
ein logischer Pegel des ersten Steuersignals (R/W) verändert wird während einer Periode bzw. Zeitdauer, wenn das zweite Steuersignal (/CS) in bzw. bei dem zweiten logischen Pegel ist, und
die Arbeitsweise des SDRAMIC wird verändert bzw. geschaltet zwischen dem Lesevorgang bzw. der Leseoperation und dem Schreibvorgang bzw. der Schreiboperation in Abhängigkeit von der Veränderung des logischen Pegels des ersten Steuersignals (R/W) ohne zurückzukehren zu einem Zustand vor dem Starten von entweder dem Lesevorgang oder dem Schreibvorgang.

3. SDRAMIC nach Anspruch 1, **dadurch gekennzeichnet, dass**
die Zugriffsvorrichtung (1340, 1338, 1336) eine Ausgabevorrichtung (1338) aufweist zum Ausgeben einer Information, welche bei der Stelle des Speicherblocks (1300) gespeichert ist, in Reaktion auf eine dritte Flanke des externen Taktsignals (RCLK).

4. SDRAMIC nach Anspruch 3, **dadurch gekennzeichnet, dass**
die Steuervorrichtung (1336) ein erstes Freigabe (enable)-Signal (EN_MSA) und ein zweites Freigabe (enable)-Signal (GLK_LSA) der Adresseingabevorrichtung (1320) zuführt in Reaktion auf den vorgegebenen Satz der Steuersignale (/CS, RFRSH, R/W, V/I) bei einer Flanke des externen Taktsignals (RCLK), und ein Ausgabefreigabesignal (OE) der Ausgabevorrichtung (1338) zuführt in Reaktion auf den vorgegebenen Satz von Steuersignalen (/CS, RFRSH, R/W, V/I) bei einer Flanke des externen Taktsignals (RCLK),
jedes, das erste Freigabesignal (EN_MSA), das zweite Freigabesignal (GLK_LSA) und das Ausgabe-Freigabe-Signal (OE) sind synchron zu einer Flanke des externen Taktsignals (RCLK),
wobei die Adresseneingabevorrichtung (1320) die erste Adresse (MSA) in Reaktion auf das erste Freigabesignal (EN_MSA) zur Verfügung stellt, die Adresseneingabevorrichtung (1320) die zweite Adresse (LSA) in Reaktion auf das zweite Freigabesignal (CLK_LSA) zur Verfügung stellt bzw. liefert, und die Ausgabevorrichtung die Information in Reaktion auf das Ausgabe-Freigabe-Signal (OE) ausgibt.

5. SDRAMIC nach Anspruch 1, **dadurch gekennzeichnet, dass** die Zugriffsvorrichtung (1340, 1338, 1336) aufweist:
eine Dateneingabevorrichtung (1340) zum Empfangen von Daten, wobei die Dateneingabevorrichtung (1340) die Daten als eine Ausgabe in Reaktion auf eine dritte Flanke des externen Taktsignals (RCLK) zur Verfügung stellt; und
eine Schreibvorrichtung (1336) zum Schreiben der Daten in den Speicherblock (1300) bei einer Stelle entsprechend der ersten Adresse (MSA) und der zweiten Adresse (LSA) in Reaktion auf eine vierte Flanke des externen Taktsignals (RCLK).

6. SDRAMIC nach Anspruch 5, **dadurch gekennzeichnet, dass**
die Steuervorrichtung (1336) ein Daten-Freigabe-Signal (CLK-DIN1, EN_DIN2) der Dateneingabevorrichtung (1340) zuführt in Reaktion auf den vorgegebenen Satz der Steuersignale (/CS, RFRSH, R/W, V/I) bei einer Flanke des externen Taktsignals (RCLK), und ein Schreib-Freigabe-Signal (WE) der Schreibvorrichtung (1336) zuführt in Reaktion auf den vorgegebenen Satz von Steuersignalen (/CS, RFRSH, R/W, V/I) bei einer Flanke des externen Taktsignals (RCLK), wobei jeweils das Datenfreigabesignal und das Schreibfreigabesignal synchron zu einer Flanke des externen Taktsignals (RCLK) sind,
wobei die Dateneingabevorrichtung (1340) die Daten in Reaktion auf das Datenfreigabesignal zur Verfügung stellt und die Schreibvorrichtung (1336) die Daten in Reaktion auf das Schreibfreigabesignal schreibt.

7. SDRAMIC nach Anspruch 1, weiter aufweisend:
einen seriellen Port bzw. Anschluss (1210) umfassend:
eine Vorrichtung (1314) zum Empfangen eines Taktsignals für den seriellen Port bzw. Anschluss (SCLK) zum Steuern des Zeitablaufs des seriellen Ports bzw. Anschlusses (1210);
eine serielle Ausgabevorrichtung (1306); und
eine Übertragungsvorrichtung (1304) zum Übertragen der seriellen Information, welche im Speicherblock (1300) gespeichert ist, zu der seriellen Ausgabevorrichtung (1306) in Reaktion auf eine dritte Flanke des externen Taktsignals (RCLK);
wobei die serielle Ausgabevorrichtung (1306) sequentiell Teile der seriellen Information ausgibt in Reaktion auf die jeweiligen Flanken des Taktsignals des seriellen Ports bzw. Anschlusses (SCLK).

8. SDRAMIC nach Anspruch 7, **dadurch gekennzeichnet, dass**
die Steuervorrichtung (1336) ein erstes Freigabesignal (EN_MSA) und ein zweites Freigabesignal (CLK_LSA) der Adresseneingabevorrichtung (1320) zuführt in Reaktion auf den vorgegebenen Satz von Steuersignalen (/CS, RFRSH, R/W, V/I) bei einer Flanke des externen Taktsignals (RCLK), und ein Transfer- bzw. Übertragungs-Freigabe-Signal (EN_DL) der Übertragungs- bzw. Transfervorrichtung (1304) zuführt in Reaktion auf den vorgegebenen Satz von Steuersignalen (/CS, RFRSH, R/W, V/I) bei einer Flanke des externen Taktsignals (RCLK),
wobei jedes, das erste Freigabesignal (EN_MSA), das zweite Freigabesignal (CLK_LSA) und das Transfer-Freigabesignal (EN_DL) synchron zu einer Flanke des externen Taktsignals (RCLK) sind,
wobei die Adresseneingabevorrichtung (1320) die erste Adresse (MSA) in Reaktion auf das erste Freigabesignal (EN_MSA) zur Verfügung stellt, die Adresseneingabevorrichtung (1320) die zweite Adresse (LSA) in Reaktion auf das zweite Freigabesignal (CLK_LSA) zur Verfügung stellt, und die Übertragungs- bzw. Transfervorrichtung (1304) die serielle Information in Reaktion auf das Transfer-Freigabe-Signal (EN_DL) überträgt.

9. SDRAMIC nach Anspruch 1, **dadurch gekennzeichnet, dass** eine Periode bzw. Zeitdauer, in welcher der logische Pegel des ersten Steuersignals (R/W) verändert wird, in einem Taktzyklus des externen Taktsignals (RCLK) enthalten ist.

10. SDRAMIC nach Anspruch 9, **dadurch gekennzeichnet, dass** die erste Adresse (MSA) beibehalten wird vor und nach der Veränderung des logischen Pegels des ersten Steuersignals (R/W).

11. SDRAMIC nach Anspruch 1, **dadurch gekennzeichnet, dass** eine Zeitdauer bzw. Periode, in welcher der logische Pegel des zweiten Steuersignals (/CS) verändert wird, in einem Taktzyklus des externen Taktsignals (RCLK) enthalten ist.

12. Verfahren zum Zugreifen auf einen Speicher in einer integrierten Schaltung mit synchronem dynamischem Speicher mit wahlfreiem Zugriff (SDRAMIC), wobei der SDRAMIC aufweist:
a) ein Speicherblock (1300) umfassend eine Mehrzahl von Speicherzellen zum Speichern einer Information;
b) eine Eingabe (1200) zum Empfang eines externen Taktsignals (RCLK);
c) eine Adresseneingabevorrichtung (1320) zum Empfang einer Adresse (MSA, LSA), welche eine Stelle einer Information definiert, welche in dem Speicherblock (1300) gespeichert ist; und
d) eine Steuervorrichtung (1366) zum Empfang eines vorgegebenen Satzes von Steuersignalen (/CS, RFRSH, R/W, V/I), welche von außerhalb des SDRAMIC zur Verfügung gestellt werden, zum Durchführen eines Übergangs von einem Zustand zu einem nächsten Zustand in Abhängigkeit von dem vorgegebenen Satz der Steuersignale (/CS, RFRSH, R/W, V/I) bei den jeweiligen Flanken des externen Taktsignals (RCLK), und zum Ausgeben eines internen Steuersignals (EN_MSA, CLK_LSA, CLK_DIN1,...., ALL, OE), welches einen Zeitablauf einer internen Arbeitsweise des SDRAMIC definiert basierend auf dem nächsten Zustand,
e) der vorgegebene Satz der Steuersignale (/CS, RFRSH, R/W, V/I) umfasst. ein erstes Steuersignal (R/W) und ein zweites Steuersignal (/CS), wobei die interne Arbeitsweise eine Schreiboperation bzw. einen Schreibvorgang darstellt, wenn das erste Steuersignal (R/W) bei einem ersten logischen Pegel (niedrig bzw. low) und das zweite Steuersignal (/CS) bei einem zweiten logischen Pegel ist, und die interne Arbeitsweise bzw. Operation stellt einen Lesevorgang bzw. eine Leseoperation dar, wenn das erste Steuersignal (R/W) bei einem dritten logischen Pegel (hoch bzw. high) ist, welcher verschieden ist von dem ersten logischen Pegel und das zweite Steuersignal (/CS) ist bei dem zweiten logischen Pegel;
**gekennzeichnet durch**
f) die Adresseneingabevorrichtung (1320) empfängt die Adresse als eine erste Adresse (MSA) und eine zweite Adresse (LSA), die Adresseneingabevorrichtung (1320) stellt die erste Adresse (MSA) als eine Ausgabe in Reaktion auf eine erste Flanke des externen Taktsignals (RCLK) zur Verfügung und stellt die zweite Adresse (LSA) als eine Ausgabe in Reaktion auf eine zweite Flanke des externen Taktsignals (RCLK) zur Verfügung, wobei die erste Flanke des externen Taktsignals (RCLK) von der zweiten Flanke des externen Taktsignals (RCLK) verschieden ist;
und
g) zugreifen auf eine Stelle in dem Speicherblock (1300) entsprechend der ersten Adresse (MSA) und der zweiten Adresse (LSA), welche von der Adresseneingabevorrichtung (1320) zur Verfügung gestellt werden.

13. System mit einer integrierten Schaltung mit einem synchronen dynamischen Speicher mit wahlfreiem Zugriff (SDRAMIC) mit:
a) einer Schaltung zum Zugreifen auf den SDRAMIC, und einem Bus (90, 100, 140), welcher die Schaltung mit dem SDRAMIC verbindet;
wobei die Schaltung aufweist:
b) eine Vorrichtung (110) zum Liefern bzw. Anlegen einer Adresse (MSA, LSA) auf den Bus (90, 100, 140), wobei die Adresse eine Stelle einer Information definiert, welche in dem Speicherblock (1300) gespeichert ist, und eine Vorrichtung (120) zum Liefern eines vorgegebenen Satzes von Steuersignalen (/CS, RFRSH, R/W, V/I) auf bzw. an den Bus (90, 100, 140), wobei der vorgegebene Satz der Steuersignale (/CS, RFRSH, V/I, R/W) auf dem Bus (90, 100, 140) bei einer Flanke eines Taktsignals (RCLK) gültig ist;
wobei der SDRAMIC aufweist:
c) einen Speicherblock (1300) umfassend eine Mehrzahl von Speicherzellen zum Speichern einer Information;
d) eine Eingabe (1200) zum Empfangen des Taktsignals (RCLK);
e) eine Adresseneingabevorrichtung (1320) zum Empfangen der Adresse (MSA, LSA) über den Bus (90, 100, 140), und
f) einer Steuervorrichtung (1366) zum Empfangen des vorgegebenen Satzes der Steuersignale (/CS, RFRSH, R/W, V/I) über den Bus (90, 100, 140), zum Durchführen eines Übergangs von einem Zustand zu einem nächsten Zustand in Abhängigkeit von dem vorgegebenen Satz der Steuersignale (/CS, RFRSH, R/W, V/I) bei den jeweiligen Flanken des Taktsignals (RCLK), und zum Ausgeben eines internen Steuersignals (EN_MSA, CLK_LSA, CLK_DIN1,...., ALL, OE), welches einen Zeitablauf einer internen Arbeitsweise des SDRAMIC definiert basierend auf dem nächsten Zustand,
g) wobei der vorgegebene Satz der Steuersignale (/CS, RFRSH, R/W, V/I) ein erstes Steuersignal (R/W) und ein zweites Steuersignal (/CS) umfasst, wobei die interne Arbeitsweise einen Schreibvorgang bzw. eine Schreiboperation darstellt, wenn das erste Steuersignal (R/W) bei einem ersten logischen Pegel (niedrig bzw. low) ist und das zweite Steuersignal (/CS) bei einem zweiten logischen Pegel ist, und die interne Arbeitsweise stellt ein Lesevorgang bzw. eine Leseoperation dar, wenn das erste Steuersignal (R/W) bei einem dritten logischen Pegel (hoch bzw. high) ist, was von dem ersten logischen Pegel verschieden ist und das zweite Steuersignal (/CS) ist bei dem zweiten logischen Pegel;
**gekennzeichnet durch**
h) die Adresseneingabevorrichtung (1320) empfängt die Adresse als eine erste Adresse (MSA) und eine zweite Adresse (LSA), wobei die erste Adresse (MSA) auf dem Bus (90, 100, 140) gültig ist bei einer ersten Flanke eines Taktsignals (RCLK) und die zweite Adresse (LSA) ist gültig auf dem Bus (90, 100, 140) bei einer zweiten Flanke des Taktsignals (RCLK), wobei die Adresseneingabevorrichtung (1320) die erste Adresse (MSA) als eine Ausgabe in Reaktion auf die erste Flanke des Taktsignals (RCLK) zur Verfügung stellt, die Adresseneingabevorrichtung (1320) stellt die zweite Adresse (LSA) als eine Ausgabe in Reaktion auf die zweite. Flanke des Taktsignals (RCLK) zur Verfügung, die erste Flanke des Taktsignals (RCLK) ist verschieden von der zweiten Flanke des Taktsignals (RCLK) und
i) der SDRAMIC weist weiter eine Zugriffsvorrichtung (1340, 1338, 1336) auf zum Zugreifen auf eine Stelle in dem Speicherblock (1300) entsprechend der ersten Adresse (MSA) und der zweiten Adresse (LSA), zur Verfügung gestellt **durch** die Adresseneingabevorrichtung (1320).

14. System nach Anspruch 13, **dadurch gekennzeichnet, dass** die Zugriffsvorrichtung (1340, 1338, 1336) eine Ausgabevorrichtung (1338) aufweist zum Ausgeben einer Information, welche bei der Stelle des Speicherblocks (1300) gespeichert, in Reaktion auf eine dritte Flanke des Taktsignals (RCLK).

15. System nach Anspruch 14, **dadurch gekennzeichnet, dass**
die Steuervorrichtung (1336) ein erstes Freigabe (enable)-Signal (EN_MSA) und ein zweites Freigabe (enable)-Signal (CLK_LSA) der Adresseneingabevorrichtung (1320) zuführt in Reaktion auf den vorgegebenen Satz der Steuersignale (/CS, RFRSH, R/W, V/I) bei einer Flanke des Taktsignals (RCLK), und ein Ausgabefreigabesignal (OE) der Ausgabevorrichtung (1338) zuführt in Reaktion auf den vorgegebenen Satz von Steuersignalen (/CS, RFRSH, R/W, V/I) bei einer Flanke des Taktsignals (RCLK),
jedes, das erste Freigabesignal (EN_MSA), das zweite Freigabesignal (CLK_LSA) und das Ausgabe-Freigabe-Signal (OE) sind synchron zu einer Flanke des Taktsignals (RCLK),
wobei die Adresseneingabevorrichtung (1320) die erste Adresse (MSA) in Reaktion auf das erste Freigabesignal (EN_MSA) zur Verfügung stellt, die Adresseneingabevorrichtung (1320) die zweite Adresse (LSA) in Reaktion auf das zweite Freigabesignal (CLK_LSA) zur Verfügung stellt bzw. liefert, und die Ausgabevorrichtung (1338) die Information in Reaktion auf das Ausgabe-Freigabe-Signal (OE) ausgibt.

16. System nach Anspruch 13, **dadurch gekennzeichnet, dass**
die Schaltung zum Zugreifen auf den SDRAMIC weiter eine Vorrichtung (110) aufweist zum Liefern bzw. Anlegen von Daten an den Bus (90, 100, 140), wobei die Daten auf dem Bus (90, 100, 140) bei einer dritten Flanke des Taktsignals (RCLK) gültig sind, und
die Zugriffsvorrichtung (1340, 1338, 1336) umfasst:
eine Dateneingabevorrichtung (1340) zum Empfangen der Daten über den Bus (90, 100, 140), wobei die Dateneingabevorrichtung (1340) die Daten als eine Ausgabe in Reaktion auf die dritte Flanke des Taktsignals (RCLK) liefert bzw. zur Verfügung stellt; und
eine Schreibvorrichtung (1336) zum Schreiben der Daten zu dem bzw. in den Speicherblock (1300) bei einer Stelle entsprechend der ersten Adresse (MSA) und der zweiten Adresse (LSA) in Reaktion auf eine vierte Flanke des Taktsignals (RCLK).

17. System nach Anspruch 16, **dadurch gekennzeichnet, dass**
die Steuervorrichtung (1336) ein Daten-Freigabe-Signal (CLK_DIN1, EN_DIN2) der Dateneingabevorrichtung (1340) zuführt in Reaktion auf den vorgegebenen Satz der Steuersignale (/CS, RFRSH, R/W, V/I) bei einer Flanke des Taktsignals (RCLK), und ein Schreib-Freigabe-Signal (WE) der Schreibvorrichtung (1336) zuführt in Reaktion auf den vorgegebenen Satz von Steuersignalen (/CS, RFRSH, R/W, V/I) bei einer Flanke des Taktsignals (RCLK), wobei jeweils das Datenfreigabesignal und das Schreibfreigabesignal synchron zu einer Flanke des Taktsignals (RCLK) sind,
wobei die Dateneingabevorrichtung (1340) die Daten in Reaktion auf das Datenfreigabesignal zur Verfügung stellt und die Schreibvorrichtung (1336) die Daten in Reaktion auf das Schreibfreigabesignal schreibt.

18. System nach Anspruch 13, **dadurch gekennzeichnet, dass** der Bus einen Adressbus (100) umfasst zum Übertragen bzw. Transportieren der ersten Adresse (MSA) und der zweiten Adresse (LSA) und einen Datenbus (90) zum Transportieren bzw. Übertragen von Daten.

## Revendications

1. Circuit intégré à mémoire à accès direct dynamique synchrone (SDRAMIC) comprenant :
a) un bloc mémoire (1300) incluant une pluralité de cellules mémoire pour stocker des informations ;
b) une entrée (1200) pour recevoir un signal d'horloge externe (RCLK) ;
c) un moyen d'entrée d'adresse (1320) pour recevoir une adresse (MSA, LSA) définissant un emplacement d'informations stockées dans ledit bloc mémoire (1300) ; et
d) un moyen de commande (1366) pour recevoir un ensemble prédéterminé de signaux de commande (/CS, RFRSH, R/W, V/I)délivré de l'extérieur de ladite SDRAMIC, pour effectuer une transition d'un état à l'état suivant en conformité avec ledit ensemble prédéterminé de signaux de commande (/CS, RFRSH, R/W, V/I) sur les bords respectifs dudit signal d'horloge externe (RCLK) et pour sortir un signal de commande interne (EN_MSA, CLK_LSA, CLK_DIN1,..., ALL, OE) définissant un cadencement de mutations internes de ladite SDRAMIC basé sur ledit état suivant,
e) ledit ensemble prédéterminé de signaux de commande (/CS, RFRSH, R/W, V/I) inclut un premier signal de commande (R/W) et un second signal de commande (/CS), ladite opération interne représente une opération d'écriture lorsque ledit premier signal de commande (R/W) se trouve dans un premier niveau logique (bas) et lorsque ledit second signal de commande (/CS) se trouve dans un second niveau logique, et ladite opération interne représente une opération de lecture lorsque ledit premier signal de commande (R/W) se trouve dans un troisième niveau logique (haut) qui est différent dudit premier niveau logique (haut) et lorsque ledit second signal de commande (/CS) se trouve dans ledit second niveau logique ;
**caractérisé par**
f) ledit moyen d'entrée d'adresse (1320) recevant ladite adresse sous forme d'une première adresse (MSA) et sous forme d'une seconde adresse (LSA), ledit moyen d'entrée d'adresse (1320) fournissant ladite première adresse (MSA) sous forme de sortie en réponse à un premier bord dudit signal d'horloge externe (RCLK), ledit moyen d'entrée d'adresse (1320) fournissant ladite seconde adresse (LSA) sous forme de sortie en réponse à un second bord dudit signal d'horloge externe (RCLK), ledit premier bord dudit signal d'horloge externe (RCLK) étant différent dudit second bord dudit signal d'horloge externe (RCLK) ; et par
g) un moyen d'accès (1340, 1338, 1336) fourni pour accéder à un emplacement dans ledit bloc mémoire (1300) correspondant à ladite première adresse (MSA) et à ladite seconde adresse (LSA) fournies par ledit moyen d'entrée d'adresse (1320).

2. SDRAMIC selon la revendication 1, **caractérisée en ce que**
un niveau logique dudit premier signal de commande (R/W) est changé pendant une période, lorsque ledit second signal de commande (/CS) se trouve dans ledit second niveau logique, et **en ce que**
ladite opération de ladite SDRAMIC est changée entre ladite opération de lecture et ladite opération d'écriture en conformité avec ledit changement de niveau logique dudit premier signal de commande (R/W) sans revenir à un état antérieur au début soit de ladite opération de lecture soit de ladite opération d'écriture.

3. SDRAMIC selon la revendication 1, **caractérisée en ce que**
ledit moyen d'accès (1340, 1338, 1336) comprend un moyen de sortie (1338) pour sortir des informations stockées audit emplacement dudit bloc mémoire (1300) en réponse à un troisième bord dudit signal d'horloge externe (RCLK).

4. SDRAMIC selon la revendication 3, **caractérisée en ce que**
ledit moyen de commande (1366) délivre un premier signal de validation (EN_MSA) et un second signal de validation (GLK_LSA) audit moyen d'entrée d'adresse (1320) en réponse audit ensemble prédéterminé de signaux de commande (/CS, RFRSH, R/W, V/I) sur un bord dudit signal d'horloge externe (RCLK) et délivre un signal de validation de sortie (OE) audit moyen de sortie (1338) en réponse audit ensemble prédéterminé de signaux de commande (/CS, RFRSH, R/W, V/I) sur un bord dudit signal d'horloge externe (RCLK),
chacun dudit premier signal de validation (EN_MSA), dudit second signal de validation (GLK_LSA) et dudit signal de validation de sortie (OE) étant synchrone avec un bord dudit signal d'horloge externe (RCLK),
dans lequel ledit moyen d'entrée d'adresse (1320) fournit ladite première adresse (MSA) en réponse audit premier signal de validation (EN_MSA), ledit moyen d'entrée d'adresse (1320) fournit ladite seconde adresse (LSA) en réponse audit second signal de validation (CLK_LSA) et dans lequel ledit moyen de sortie sort lesdites informations en réponse audit signal de validation de sortie (OE).

5. SDRAMIC selon la revendication 1, **caractérisée en ce que** ledit moyen d'accès (1340, 1338, 1336) comprend :
un moyen d'entrée de données (1340) pour recevoir des données, ledit moyen d'entrée de données (1340) fournissant lesdites données sous forme de sortie en réponse à un troisième bord dudit signal d'horloge externe (RCLK) ; et
un moyen d'écriture (1336) pour écrire lesdites données dans ledit bloc mémoire (1300) à un emplacement correspondant à ladite première adresse (MSA) et à ladite seconde adresse (LSA) en réponse à un quatrième bord dudit signal d'horloge externe (RCLK).

6. SDRAMIC selon la revendication 5, **caractérisée en ce que**
ledit moyen de commande (1366) délivre un signal de validation de données (CLK_DIN1, EN_DIN2) audit moyen d'entrée de données (1340) en réponse audit ensemble prédéterminé de signaux de commande (/CS, RFRSH, R/W, V/I) sur un bord dudit signal d'horloge externe (RCLK) et délivre un signal de validation d'écriture (WE) audit moyen d'écriture (1336) en réponse audit ensemble prédéterminé de signaux de commande (/CS, RFRSH, R/W, V/I) sur un bord dudit signal d'horloge externe (RCLK), chacune desdites données (1336) en réponse audit ensemble prédéterminé de signaux de commande (/CS, RFRSH, R/W, V/I) sur un bord dudit signal d'horloge externe (RCLK), chacun dudit signal de validation de données et dudit signal de validation d'écriture étant synchrone avec un bord dudit signal d'horloge externe (RCLK),
dans lequel ledit moyen d'entrée de données (1340) fournit lesdites données en réponse audit signal de validation de données et dans lequel ledit moyen d'écriture (1336) écrit lesdites données en réponse audit signal de validation d'écriture.

7. SDRAMIC selon la revendication 1, comprenant en outre :
un port série (1210) incluant :
un moyen (1314) pour recevoir un signal d'horloge de port série (SCLK) pour commander la synchronisation dudit port série (1210) ;
un moyen de sortie série (1306) ; et
un moyen de transfert (1304) pour transférer les informations série stockées dans ledit bloc mémoire (1300) vers ledit moyen de sortie série (1336) en réponse à un troisième bord dudit signal d'horloge externe (RCLK) ;
dans lequel ledit moyen de sortie série (1306) sort séquentiellement des portions desdites informations série en réponse aux bords respectifs dudit signal d'horloge de port série (SCLK).

8. SDRAMIC selon la revendication 7, **caractérisée en ce que**
ledit moyen de commande (1366) délivre un premier signal de validation (EN_MSA) et un second signal de validation (CLK_LSA) audit moyen d'entrée d'adresse (1320) en réponse audit ensemble prédéterminé de signaux de commande (/CS, RFRSH, R/W, V/I) sur un bord dudit signal d'horloge externe (RCLK) et délivre un signal de validation de transfert (EN_DL) audit moyen de transfert (1304) en réponse audit ensemble prédéterminé de signaux de commande (/CS, RFRSH, R/W, V/I) sur un bord dudit signal d'horloge externe (RCLK),
chacun dudit premier signal de validation (EN_MSA), dudit second signal de validation (CLK_LSA) et dudit signal de validation de transfert (EN_DL) étant synchrone avec un bord dudit signal d'horloge externe (RCLK),
dans laquelle ledit moyen d'entrée d'adresse (1320) fournit ladite première adresse (MSA) en réponse audit premier signal de validation (EN_MSA), ledit moyen d'entrée d'adresse (1320) fournit ladite seconde adresse (LSA) en réponse audit second signal de validation (CLK_LSA) et ledit moyen de transfert (1304) transfère lesdites informations série en réponse audit signal de validation de transfert (EN_DL).

9. SDRAMIC selon la revendication 1, **caractérisée en ce qu'**une période dans laquelle ledit niveau logique dudit premier signal de commande (R/W) est changé est incluse dans un cycle d'horloge dudit signal d'horloge externe (RCLK).

10. SDRAMIC selon la revendication 9, **caractérisée en ce que** ladite première adresse (MSA) est maintenue avant et après ledit changement de niveau logique dudit premier signal de commande (R/W).

11. SDRAMIC selon la revendication 1, **caractérisée en ce qu'**une période dans laquelle ledit niveau logique dudit second signal de commande (/CS) est changé est incluse dans un cycle d'horloge dudit signal d'horloge externe (RCLK).

12. Procédé pour accéder à une mémoire dans un circuit intégré à mémoire à accès direct dynamique synchrone (SDRAMIC), la SDRAMIC comprenant :
a) un bloc mémoire (1300) incluant une pluralité de cellules mémoire pour stocker des informations ;
b) une entrée (1200) pour recevoir un signal d'horloge externe (RCLK) ;
c) un moyen d'entrée d'adresse (1320) pour recevoir une adresse (MSA, LSA) définissant un emplacement d'informations stockées dans ledit bloc mémoire (1300) ; et
d) un moyen de commande (1366) pour recevoir un ensemble prédéterminé de signaux de commande (/CS, RFRSH, R/W, V/I) appliqué de l'extérieur de ladite SDRAMIC, pour induire une transition d'un état à l'état suivant conformément audit ensemble prédéterminé de signaux de commande (/CS, RFRSH, R/W, V/I) sur les bords respectifs dudit signal d'horloge externe (RCLK) et pour sortir un signal de commande interne (EN_MSA, CLK_LSA, CLK_DIN1,...,TOUS, OE) définissant le cadencement des mutations internes de ladite SDRAMIC basé sur ledit état suivant,
e) ledit ensemble prédéterminé de signaux de commande (/CS, RFRSH, R/W, V/I) inclut un premier signal de commande (R/W) et un second signal de commande (/CS), ladite opération interne représente une opération d'écriture lorsque ledit premier signal de commande (R/W) se trouve dans un premier niveau logique (bas) et que ledit second signal de commande (/CS) se trouve dans un second niveau logique, et ladite opération interne représente une opération de lecture lorsque ledit premier signal de commande (R/W) se trouve dans un troisième niveau logique (haut) qui est différent dudit premier niveau logique et que ledit second signal de commande (/CS) se trouve dans ledit second niveau logique ;
**caractérisé par**
f) ledit moyen d'entrée d'adresse (1320) recevant ladite adresse sous forme d'une première adresse (MSA) et d'une seconde adresse (LSA), ledit moyen d'entrée d'adresse (1320) fournissant ladite première adresse (MSA) sous la forme d'une sortie en réponse à un premier bord dudit signal d'horloge externe (RLCK) et fournissant ladite seconde adresse (LSA) sous forme de sortie en réponse à un second bord dudit signal d'horloge externe (RCLK), ledit premier bord dudit signal d'horloge externe (RCLK) étant différent dudit second bord dudit signal d'horloge externe (RCLK) ; et par
g) l'accès à un emplacement dans ledit bloc mémoire (1300) correspondant à ladite première adresse (MSA) et à ladite seconde adresse (LSA) fournies par ledit moyen d'entrée d'adresse (1320).

13. Système avec circuit intégré à mémoire à accès direct dynamique synchrone (SDRAMIC) comprenant :
a) un circuit pour accéder à ladite SDRAMIC et un bus (90, 100, 140) reliant ledit circuit à ladite SDRAMIC ;
ledit circuit comprenant :
b) un moyen (110) pour fournir une adresse (MSA, LSA) sur ledit bus (90, 100, 140), ladite adresse définissant un emplacement d'informations stockées dans ledit bloc mémoire (1300) et un moyen (120) pour fournir un ensemble prédéterminé de signaux de commande (/CS, RFRSH, R/W, V/I) sur ledit bus (90, 100, 140), ledit ensemble prédéterminé de signaux de commande (/CS, RFRSH, V/I, R/W) étant valide sur ledit bus (90, 100, 140) sur un bord d'un signal d'horloge (RCLK) ;
ladite SDRAMIC comprenant :
c) un bloc mémoire (1300) incluant une pluralité de cellules mémoire pour stocker des informations ;
d) une entrée (1200) pour recevoir ledit signal d'horloge (RCLK) ;
e) un moyen d'entrée d'adresse (1320) pour recevoir ladite adresse (MSA, LSA) à travers ledit bus (90, 100, 140), et
f) un moyen de commande (1366) pour recevoir ledit ensemble prédéterminé de signaux de commande (/CS, RFRSH, R/W, V/I) à travers ledit bus (90, 100, 140), pour effectuer une transition d'un état à l'état suivant en conformité avec ledit ensemble prédéterminé de signaux de commande (/CS, RFRSH, R/W, V/I) sur les bords respectifs dudit signal d'horloge (RCLK) et pour sortir un signal de commande interne (EN_MSA, CLK_LSA, CLK_DIN1,..., ALL, OE) définissant un cadencement de mutations internes de ladite SDRAMIC basé sur ledit état suivant,
g) ledit ensemble prédéterminé de signaux de commande (/CS, RFRSH, R/W, V/I) inclut un premier signal de commande (R/W) et un second signal de commande (/CS), ladite opération interne représente une opération d'écriture lorsque ledit premier signal de commande (R/W) se trouve dans un premier niveau logique (bas) et que ledit second signal de commande (/CS) se trouve dans un second niveau logique, et ladite opération interne représente une opération de lecture lorsque ledit premier signal de commande (R/W) se trouve dans un troisième niveau logique (haut) qui est différent dudit premier niveau logique et que ledit second signal de commande (/CS) se trouve dans ledit second niveau logique ;
**caractérisé par**
h) ledit moyen d'entrée d'adresse (1320) recevant ladite adresse sous forme de première adresse (MSA) et de seconde adresse (LSA), ladite première adresse (MSA) étant valide sur ledit bus (90, 100, 140) sur un premier bord d'un signal d'horloge (RCLK) et ladite seconde adresse (LSA) étant valide sur ledit bus (90, 100, 140) sur un second bord dudit signal d'horloge (RCLK), ledit moyen d'entrée d'adresse (1320) fournissant ladite première adresse (MSA) sous forme de sortie en réponse audit premier bord dudit signal d'horloge (RCLK), ledit moyen d'entrée d'adresse (1320) fournissant ladite seconde adresse (LSA) sous forme de sortie en réponse audit second bord dudit signal d'horloge (RCLK), ledit premier bord dudit signal d'horloge (RCLK) étant différent dudit second bord dudit signal d'horloge (RCLK) ; et par
i) ladite SDRAMIC comprenant en outre un moyen d'accès (1340, 1338, 1336) pour accéder à un emplacement dans ledit bloc mémoire (1300) correspondant à ladite première adresse (MSA) et à ladite seconde adresse (LSA) fournies par ledit moyen d'entrée d'adresse (1320).

14. Système selon la revendication 13, **caractérisé en ce que** ledit moyen d'accès (1340, 1338, 1336) comprend un moyen de sortie (1338) pour sortir des informations stockées audit emplacement dudit bloc mémoire (1300) en réponse à un troisième bord dudit signal d'horloge (RCLK).

15. Système selon la revendication 14, **caractérisé en ce que**
ledit moyen de commande (1366) délivre un premier signal de validation (EN_MSA) et un second signal de validation (CLK_LSA) audit moyen d'entrée d'adresse (1320) en réponse audit ensemble prédéterminé de signaux de commande (/CS, RFRSH, R/W, V/I) sur un bord dudit signal d'horloge (RCLK) et délivre un signal de validation de sortie (OE) audit moyen de sortie (1338) en réponse audit ensemble prédéterminé de signaux de commande (/CS, RFRSH, R/W, V/I) sur un bord dudit signal d'horloge (RCLK),
chacun dudit premier signal de validation (EN_MSA), dudit second signal de validation (CLK_LSA) et dudit signal de validation de sortie (OE) étant synchrone avec un bord dudit signal d'horloge (RCLK),
dans lequel ledit moyen d'entrée d'adresse (1320) fournit ladite première adresse (MSA) en réponse audit premier signal de validation (EN_MSA), ledit moyen d'entrée d'adresse (1320) fournit ladite seconde adresse (LSA) en réponse audit second signal de validation (CLK_LSA) et ledit moyen de sortie (1338) sort lesdites informations en réponse audit signal de validation de sortie (OE).

16. Système selon la revendication 13, **caractérisé en ce que**
ledit circuit pour accéder à ladite SDRAMIC comprend en outre un moyen (110) pour fournir des données sur ledit bus (90, 100, 140), lesdites données étant valides sur ledit bus (90, 100, 140) sur un troisième bord dudit signal d'horloge (RCLK), et **en ce que**
ledit moyen d'accès (1340, 1338, 1336) comprend :
un moyen d'entrée de données (1340) pour recevoir lesdites données à travers ledit bus (90, 100, 140), ledit moyen d'entrée de données (1340) fournissant lesdites données sous forme de sortie en réponse audit troisième bord dudit signal d'horloge (RCLK) ; et
un moyen d'écriture (1336) pour écrire lesdites données sur ledit bloc mémoire (1300) à un emplacement correspondant à ladite première adresse (MSA) et à ladite seconde adresse (LSA) en réponse à un quatrième bord dudit signal d'horloge (RCLK).

17. Système selon la revendication 16, **caractérisé en ce que**
ledit moyen de commande (1366) délivre un signal de validation de données (CLK_DIN1, EN_DIN2) audit moyen d'entrée de données (1340) en réponse audit ensemble prédéterminé de signaux de commande (/CS, RFRSH, R/W, V/I) sur un bord dudit signal d'horloge (RCLK) et délivre un signal de validation d'écriture (WE) audit moyen d'écriture (1336) en réponse audit ensemble prédéterminé de signaux de commande (/CS, RFRSH, R/W, V/I) sur un bord dudit signal d'horloge (RCLK), chacun dudit signal de validation de données et dudit signal de validation d'écriture étant synchrone avec un bord dudit signal d'horloge (RCLK),
dans lequel ledit moyen d'entrée de données (1340) fournit lesdites données en réponse audit signal de validation de données et dans lequel ledit moyen d'écriture (1336) écrit lesdites données en réponse audit signal de validation d'écriture.

18. Système selon la revendication 13, **caractérisé en ce que** ledit bus inclut un bus d'adresse (100) pour acheminer ladite première adresse (MSA) et ladite seconde adresse (LSA), et un bus de données (90) pour acheminer des données.
